# EUROPEAN PATENT APPLICATION

(11) **EP 1 595 933 A1**
(43) Date of publication of application: **16.11.2005**
(21) Application number: 04712176.9
(22) Date of filing: 18.02.2004
(51) Int. Cl.: C09K 11/06, H05B 33/14

(54) **MATERIAL FOR ORGANIC ELECTROLUMINESCENT DEVICE AND ORGANIC ELECTROLUMINESCENT DEVICE USING SAME**

(30) Priority: 20.02.2003 JP 2003042625; 18.11.2003 JP 2003387855
(71) Applicant: IDEMITSU KOSAN CO., LTD., Tokyo 100-8321 (JP)
(72) Inventor: TOMITA, Seiji, Sodegaura-shi, Chiba 299-0293 (JP); IWAKUMA, Toshihiro, Sodegaura-shi, Chiba 299-0293 (JP); ARAKANE, Takashi, Sodegaura-shi, Chiba 299-0293 (JP); YAMAMICHI, Keiko, Sodegaura-shi,Chiba 299-0293 (JP); HOSOKAWA, Chishio, Sodegaura-shi, Chiba 299-0293 (JP)
(74) Representative: Gille Hrabal Struck Neidlein Prop Roos
(86) International application number: PCT/JP2004/001796
(87) International publication number: WO 2004/074399

(57) **Abstract**

A material for organic electroluminescence device with specific structure having poor symmetry. An organic electroluminescence device comprising a cathode, an anode and an organic thin film layer which is sandwiched between the cathode and the anode and comprises at least one layer, wherein at least one layer in the organic thin film layer contains a material for the organic electroluminescence device described above. An organic electroluminescence device with excellent efficiency of light emission, without pixel defects and which is superior in heat resistance is obtained.

## Description

### TECHNICAL FIELD

The present invention relates to a material for an organic electroluminescent ("electroluminescent" will be referred to as "EL", hereinafter) device and an organic EL device using the same. More particularly, the present invention relates to a material for organic EL devices which exhibits a great efficiency of light emission, few defects of a pixel, and is superior in heat resistance. Further, the present invention relates to an organic EL device using the preceding material.

### BACKGROUND ART

An organic electroluminescence ("electroluminescence" will be also occasionally referred to as "EL", hereinafter) device is a spontaneous light emitting device which utilizes the principle that a fluorescent substance emits light by energy of recombination of holes injected from an anode and electrons injected from a cathode when an electric field is applied. Since an organic EL device of the laminate type driven under a low electric voltage was reported by C. W. Tang of Eastman Kodak Company (C. W. Tang and S. A. Vanslyke, Applied Physics Letters, Volume 51, Pages 913, 1987), many studies have been conducted on organic EL devices using organic materials as the constituting materials. Tang et al. used a laminate structure using tris(8-hydroxyquinolinol)aluminum for the light emitting layer and a triphenyldiamine derivative for the hole transporting layer. Advantages of the laminate structure are that the efficiency of hole injection into the light emitting layer can be increased, that the efficiency of forming excited particles which are formed by blocking and recombining electrons injected from the cathode can be increased, and that excited particles formed among the light emitting layer can be enclosed. As the structure of the organic EL device, a two-layered structure having a hole transporting (injecting) layer and an electron transporting and light emitting layer and a three-layered structure having a hole transporting (injecting) layer, a light emitting layer and an electron transporting (injecting) layer are well known. To increase the efficiency of recombination of injected holes and electrons in the devices of the laminate type, the structure of the device and the process for forming the device have been studied.

As the light emitting material of the organic EL device, chelate complexes such as tris(8-quinolinolato)aluminum, coumarine derivatives, tetraphenylbutadiene derivatives, bisstyrylarylene derivatives and oxadiazole derivatives are known. It is reported that light in the visible region ranging from blue light to red light can be obtained by using these light emitting materials, and development of a device exhibiting color images is expected (For example, Japanese Unexamined Patent Application Laid-Open Nos. Heisei 8(1996)-239655, Heisei 7(1995)-138561 and Heisei 3(1991)-200289).

It is recently proposed that an organic phosphorescent materials is used in the light emitting layer of an organic EL device in combination with a light emitting material (for example, D. F. O'Brien, M. A. Baldo et al., "Improved energy transfer in electrophosphorescent devices", Applied Physics Letters, Vol. 74, No. 3, Pages 442 to 444, January 18, 1999; and M. A. Baldo et al., "Very high-efficiency green organic light-emitting devices based on electrophosphorescence", Applied Physics Letters, Vol. 75, No. 1, Pages 4 to 6, July 5, 1999).

As described above, a great efficiency of light emission is achieved by utilizing an organic phosphorescent material excited to the singlet state and the triplet state in the light emitting layer of an organic EL device. It is considered that singlet excimers and triplet excimers are formed in relative amounts of 1:3 due to the difference in the multiplicity of spin when electrons and holes are recombined in an organic EL device. Therefore, it is expected that an efficiency of light emission 3 to 4 times as great as that of a device utilizing fluorescence alone can be achieved by utilizing a phosphorescent light emitting material.

In the organic EL devices such as those described above, constructions in which layers such as an anode, an organic light emitting layer, an electron transporting layer (a hole blocking layer), an electron injecting layer and a cathode are successively laminated are used so that light emission in the condition excited to the triplet state or from excimers in the triplet state is not quenched (for example, the United States Patent No. 6,097,147, and International Patent Application Published under PCT No. WO01/41512). In these patent literature, 4,4-N,N dicarbazole biphenyl have been used as a host compound. However, there were problems that the host compound tends to crystallize because its glass transition temperature is 110 °C or less and further, because it is too symmetrical and that short circuit or pixel defect generates in the heat resistance test of the organic EL device.

Furthermore, it was found that a crystal growth generates at the position where there is a foreign matter or a protrusion of an electrode in an occasion of vapor deposition, and that the defects generate more than the primary stage before the heat resistance test. Still further, carbazole derivatives having a symmetry of order 3 are used as the host compound. However, it is too symmetrical to evade the crystal growth generation at the position where there is a foreign matter or a protrusion of an electrode in an occasion of vapor deposition, or to evade the defects generation more than the primary stage before the heat resistance test.

### DISCLOSURE OF THE INVENTION

The present invention has been made to overcome the above problems. An object of the present invention is to provide materials for organic EL devices having an excellent efficiency of light emission, without pixel defects and superior in heat resistance. Another object of the present invention is to provide an organic EL device utilizing the materials.

As a result of extensive researches for overcoming the above problems, the inventors have found that organic EL devices made by using as a material therefor, a compound with poor symmetry are capable of achieving the above objects. The present invention has been accomplished on the basis of the above finding.

The present invention provides a material for organic EL devices which comprises a compound represented by following general formula (1): 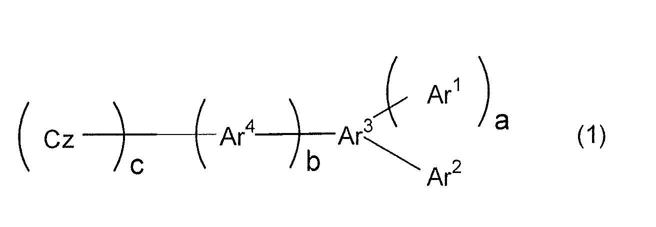 wherein Cz represents a carbazolyl group, an arylcarbazoleyl group having 18 to 60 carbon atoms, an azacarbazolyl group, an arylazacarbazoleyl group having 18 to 60 carbon atoms, an acridinyl group, a phenoxazinyl group or dibenzoazevinyl group each may have a substituent; Ar¹ and Ar² each independently represents a substituted or unsubstituted aryl group having 6 to 60 carbon atoms or a substituted or unsubstituted heterocyclic group having 3 to 60 carbon atoms; Ar³ represents an aromatic hydrocarbon group having 6 to 60 carbon atoms or a substituted or unsubstituted heterocyclic group having 3 to 60 carbon atoms; Ar⁴ represents a substituted or unsubstituted benzene residue, a substituted or unsubstituted thiophene residue, a substituted or unsubstituted triazole residue, a substituted or unsubstituted fluorene residue or a substituted or unsubstituted spirobifluorene residue;
a represents an integer of 0 or 1, b represents an integer of 0 to 4, and c represents an integer of 1 to 3; when there are plural of Cz and when there are plural of Ar⁴, they may be the same with or different from each other;
with a proviso that when a= 0 and c=1, a case where both Ar³ and Ar⁴ represent benzene residues and Ar² represents a phenyl carbazolyl group or a carbazolyl group is omitted; further, when a= 1, b= 0 and c= 1, a case where Ar³ represents a benzene residue and both Ar¹ and Ar² represent phenyl carbazolyl groups is omitted; and furthermore, when b= 0 and c= 1, a case where Ar³ represents a benzene residue and all of Ar¹, Ar² and Cz represent a carbazolyl group or a phenyl carbazolyl group is omitted.

The present invention also provides an organic EL device comprising a cathode, an anode and an organic thin film layer which is sandwiched between the cathode and the anode and comprises at least one layer, wherein at least one layer in the organic thin film layer contains a material for organic EL devices described above.

### THE PREFERRED EMBODIMENT TO CARRY OUT THE INVENTION

The present invention provides a material for organic EL devices which comprises a compound represented by following general formula (1):

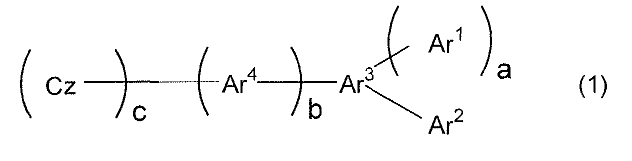

In general formula (1), Cz represents a carbazolyl group, an arylcarbazoleyl group having 18 to 60 carbon atoms, an azacarbazolyl group, an arylazacarbazoleyl group having 18 to 60 carbon atoms, an acridinyl group, a phenoxazinyl group or dibenzoazevinyl group each may have a substituent.

Examples of a group at an aryl site in the arylcarbazoleyl group or the arylazacarbazoleyl group include phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenyl group, 3-biphenyl group, 4-biphenyl group, p-terphenyl-4-yl group, p-terphenyl-3-yl group, p-terphenyl-2-yl group, m-terphenyl-4-yl group, m- terphenyl-3-yl group, m-terphenyl-2-yl group, o-tolyl group, m-tolyl group, p-tolyl group, p-t-butylphenyl group, p-(2-phenylpropyl) phenyl group, 3-methyl-2-naphthyl group, 4-methyl-1-naphthyl group, 4-methyl-1-anthryl group, 4'-methlbiphenyl-yl group, 4"-t-butyl-p-terphenyl-4-yl group, etc. Preferable examples of the above group include phenyl group, biphenyl group, tolyl group, isopropylphenyl group, t-butylphenyl group, etc.

In general formula (1), Ar¹ and Ar² each independently represents a substituted or unsubstituted aryl group having 6 to 60 carbon atoms or a substituted or unsubstituted heterocyclic group having 3 to 60 carbon atoms. It is preferable that Ar¹ and Ar² each independently represents a substituted or unsubstituted aryl group having 6 to 20 carbon atoms or a substituted or unsubstituted heterocyclic group having 3 to 20 carbon atoms. It is more preferable that Ar¹ and Ar² each independently represents phenyl group, biphenyl group, naphthyl group, phenanthryl group, pyridyl group, pyrimidinyl group or triazinyl group.

Examples of the above aryl group include phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenyl group, 3-biphenyl group, 4-biphenyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl) phenyl group, 3-methyl-2-naphthyl group, 4-methyl-1-naphthyl group, 4-methyl-1-anthryl group, 4'-methylbiphenyl-yl group, 4"-t-butyl-p-terphenyl-4-yl group, etc. Preferable examples of the above aryl group include phenyl group, naphthyl group, pyrenyl group, biphenyl group, terphenyl group, tolyl group, isopropylphenyl group, etc.

Examples of the above heterocyclic group include 1-pyrrolyl group, 2-pyrrolyl group, 3-pyrrolyl group, pyrazinyl group, 2-pyridinyl group, 3-pyridinyl group, 4-pyridinyl group, 1-indolyl group, 2-indolyl group, 3-indolyl group, 4-indolyl group, 5-indolyl group, 6-indolyl group, 7-indolyl group, 1-iso indolyl group,2-iso indolyl group, 3-iso indolyl group, 4-iso indolyl group, 5- iso indolyl group, 6-iso indolyl group, 7-iso indolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-carbazolyl group, 2-carbazolyl group, 3-carbazolyl group, 4-carbazolyl group, 9-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthroline-2-yl group, 1,7-phenanthroline-3-yl group, 1,7-phenanthroline-4-yl group, 1,7-phenanthroline-5-yl group, 1,7-phenanthroline-6-yl group, 1,7-phenanthroline-8- yl group, 1,7-phenanthroline-9-yl group, 1,7-phenanthroline-10-yl group, 1,8-phenanthroline-2-yl group, 1,8-phenanthroline-3-yl group, 1,8-phenanthroline-4-yl group, 1,8-phenanthroline-5-yl group, 1,8-phenanthroline-6-yl group, 1,8-phenanthroline-7-yl group, 1,8-phenanthroline-9-yl group, 1,8-phenanthroline-10-yl group, 1,9-phenanthroline-2-yl group, 1,9-phenanthroline-3-yl group, 1,9-phenanthroline-4-yl group, 1,9-phenanthroline-5-yl group, 1,9-phenanthroline-6-yl group, 1,9-phenanthroline-7-yl group, 1,9-phenanthroline-8-yl group, 1,9-phenanthroline-10-yl group, 1,10-phenanthroline-2-yl group, 1,10-phenanthroline-3-yl group, 1,10-phenanthroline-4-yl group, 1,10-phenanthroline-5-yl group, 2,9-phenanthroline-1-yl group, 2,9-phenanthroline-3-yl group, 2,9-phenanthroline-4-yl group, 2,9-phenanthroline-5-yl group, 2,9-phenanthroline-6-yl group, 2,9-phenanthroline-7-yl group, 2,9-phenanthroline-8-yl group, 2,9-phenanthroline-10-yl group, 2,8-phenanthroline-1-yl group, 2,8-phenanthroline-3-yl group, 2,8-phenanthroline-4-yl group, 2,8-phenanthroline-5-yl group, 2,8-phenanthroline-6-yl group, 2,8-phenanthroline-7-yl group, 2,8-phenanthroline-9-yl group, 2,8-phenanthroline-10-yl group, 2,7-phenanthroline-1-yl group, 2,7-phenanthroline-3-yl group, 2,7-phenanthroline-4-yl group, 2,7-phenanthroline-5-yl group, 2,7-phenanthroline-6-yl group, 2,7-phenanthroline-8- yl group, 2,7-phenanthroline-9-yl group, 2,7-phenanthroline-10-yl group, 1-phenazinyl group, 2-phenazinyl group, 1-phenothiazinyl group, 2-phenothiazinyl group, 3-phenothiazinyl group, 4-phenothiazinyl group, 10-phenothiazinyl group, 1-phenoxazinyl group, 2-phenoxazinyl group, 3-phenoxazinyl group, 4-phenoxazinyl group, 10-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrole-1-yl group, 2-methylpyrrole-3-yl group, 2-methylpyrrole-4-yl group, 2-methylpyrrole-5-yl group, 3-methylpyrrole-1-yl group, 3-methylpyrrole-2-yl group, 3-methylpyrrole-4-yl group, 3-methylpyrrole-5-yl group, 2-t-butylpyrrole-4-yl group, 3-(2-phenylpropyl) pyrrole-1-yl group, 2-methyl-1-indolyl group, 4-methyl-1-indolyl group, 2-methyl-3-indolyl group, 4-methyl-3-indolyl group, 2-t-butyl 1-indolyl group, 4-t-butyl 1-indolyl group, 2-t-butyl 3-indolyl group, 4-t-butyl 3-indolyl group, arylcarbazoleyl group, azacarbazolyl group, arylazacarbazoleyl group, phenoxazinyl group, dibenzo azenyl group, etc. Preferable examples of the above heterocyclic group include carbazolyl group, arylcarbazoleyl group, azacarbazolyl group, arylazacarbazoleyl group, acridinyl group, phenoxazinyl group, dibenzo azenyl group, benzimidazole group, benzothiazole group, benzo-N-allyl imidazole group, etc.

In general formula (1), Ar³ represents an aromatic hydrocarbon group having 6 to 60 carbon atoms or a substituted or unsubstituted heterocyclic group having 3 to 60 carbon atoms. It is preferable that Ar³ represents a substituted or unsubstituted aromatic hydrocarbonyl group having 6 to 20 carbon atoms or a substituted or unsubstituted heterocyclic group having 3 to 20 carbon atoms. It is more preferable that Ar³ represents a residue group of benzene, biphenyl, naphthalene, phenanthrene, pyridine, pyrimidine and triazine, and among these, the residue group of benzene is the most preferable.

Specific examples of the aromatic hydrocarbon group correspond to divalent or trivalent compounds obtainable by removing hydrogen atom from the foregoing specific examples of the aryl group represented by Ar¹ and Ar², preferable examples corresponding similarly.

Specific examples of the heterocyclic group correspond to divalent or trivalent compounds obtainable by removing hydrogen atom from the foregoing specific examples of the heterocyclic group represented by Ar¹ and Ar², preferable examples corresponding similarly.

In general formula (1), Ar⁴ represents a substituted or unsubstituted benzene residue, a substituted or unsubstituted thiophene residue, a substituted or unsubstituted triazole, a substituted or unsubstituted fluorene residue or a substituted or unsubstituted spirobifluorene residue. In the case where the fluorene residue, the thiophene residue or the spirobifluorene residue has plural of substituent, the subsituents may bond each other to form a ring structure.

Further, examples of - (Ar⁴)_{b} - include the following structure: 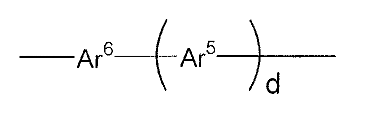 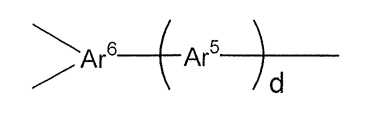 or 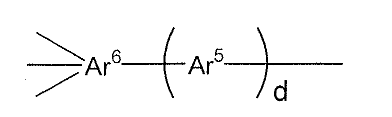 wherein Ar⁵ and Ar⁶ each independently represents the same as Ar⁴, d represents an integer of 0 to 3, and when there are plural of Ar⁵, they may be the same with or different from each other.

In general formula (1), a represents an integer of 0 or 1, b represents an integer of 0 to 4, and c represents an integer of 1 to 3. When there are plural of Cz and when there are plural of Ar⁴, they may be the same with or different from each other.

With a proviso that when a= 0 and c= 1, a case where both Ar³ and Ar⁴ represent benzene residues and Ar² represents a phenyl carbazolyl group or a carbazolyl group is omitted. Further, when a= 1, b= 0 and c= 1, a case where Ar³ represents a benzene residue and both Ar¹ and Ar² represent phenyl carbazolyl groups is omitted. Furthermore, when b= 0 and c= 1, a case where Ar³ represents a benzene residue and all of Ar¹, Ar² and Cz represent a carbazolyl group or a phenyl carbazolyl group is omitted.

In general formula (1), it is preferable that a= 0, and that a= 0 and b= 0, or a= 0, b= 0 and c represents an integer of 2 or 3.

Typical substituents of the foregoing Cz or Ar¹ to Ar⁶ each independently include halogen atom, hydroxyl group, amino group, nitro group, cyano group, alkyl group, alkenyl group, cycloalkyl group, alkoxy group, aromatic hydrocarbon group, aromatic heterocycle group, aralkyl group, aryloxy group, aryloxycarbonyl group, alkyl fluoride group, aryl fluoride group, carboxyl group, etc.

Examples of the halogen atom include fluorine atom, chlorine atom, bromine atom and iodine atom.

The amino group is a group represented by -NX¹X². Examples of the atom and the group which X¹ and X² each independently represent include hydrogen atom, methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxy-isopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromolsopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-trilodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group, 1,2,3-trinitropropyl group, phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 4-styrylphenyl group, 1-pyrenyl group, 2-pyrenyl group, 4-pyrenyl group, 2-biphenyl group, 3-biphenyl group, 4-biphenyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2- naphthyl group, 4-methyl-1-naphthyl group, 4-methyl-1-anthryl group, 4'-methylbiphenyl-yl group, 4"-t-butyl-p-terphenyl-4-yl group, 2-pyrrolyl group, 3-pyrrolyl group, pyradinyl group, 2-pyridinyl group, 3-pyridinyl group, 4-pyridinyl group, 2-indolyl group, 3-indolyl group, 4-indolyl group, 5-indolyl group, 6-indolyl group, 7-indolyl group, 1-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxanyl group, 5-quinoxanyl group, 6-quinoxanyl group, 1-carbazolyl group, 2-carbazolyl group, 3-carbazolyl group, 4-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiazinyl group, 2-phenothiazinyl group, 3-phenothiazinyl group, 4-phenothiazinyl group, 1-phenoxazinyl group, 2-phenoxazinyl group, 3-phenoxazinyl group, 4-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methyl-pyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group and 4-t-butyl-3-indolyl group.

Examples of the alkyl group described above include methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxy-isopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminolsopropyl group, 2,3-diamino-t-butyl group, 1,2,3-triamino-propyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group and 1,2,3-trinitropropyl group.

Examples of the alkenyl group described above include vinyl group, aryl group, 1-butenyl group, 2-butenyl group, 3-butenyl group, 1,3-butadienyl group, 1-methylvinyl group, styryl group, 2,2-diphenylvinyl group, 1,2-diphenylvinyl group, 1-methylallyl group, 1,1-dimethylallyl group, 2-methylallyl group, 1-phenylallyl group, 2-phenylallyl group, 3-phenylallyl group, 3,3-diphenylallyl group, 1,2-dimethylallyl group, 1-phenyl-1-butenyl group and 3-phenyl-1-butenyl group.

Examples of the cycloalkyl group described above include cyclopropyl group, cyclobutyl group, cyclopentyl group, cyclohexyl group and 4-methylcyclohexyl group.

The alkoxyl group described above is represented by - OY. Examples of the group represented by Y include methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxy-isopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-dilodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group and 1,2,3-trinitropropyl group.

Examples of the aromatic hydrocarbon group described above include phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-napbthacenyl group, 2-naphthacenyl group, 9-naphthacenyl group, 1-pyrenyl group, 2-pyrenyl group, 4-pyrenyl group, 2-biphenyl group, 3-biphenyl group, 4-biphenyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenyl-yl group and 4"-t-butyl-p-terphenyl-4-yl group.

Examples of the aromatic heterocyclic group described above include 1-pyrrolyl group, 2-pyrrolyl group, 3-pyrrolyl group, pyradinyl group, 2-pyridinyl group, 3-pyridinyl group, 4-pyridinyl group, 1-indolyl group, 2-indolyl group, 3-indolyl group, 4-indolyl group, 5-indolyl group, 6-indolyl group, 7-indolyl group, 1-isoindolyl group, 2-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxanyl group, 5-quinoxanyl group, 6-quinoxanyl group, 1-carbazolyl group, 2-carbazolyl group, 3-carbazolyl group, 4-carbazolyl group, 9-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiazinyl group, 2-phenothiazinyl group, 3-phenothiazinyl group, 4-phenothiazinyl group, 10-phenothiazinyl group, 1-phenoxazinyl group, 2-phenoxazinyl group, 3-phenoxazinyl group, 4-phenoxazinyl group, 10-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-methylpyrrol-4-yl group, 3-methylpyrrol-5-yl group, 2-t-butylpyrrol-4-yl group, 3-(2-phenylpropyl)pyrrol-1-yl group,2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group and 4-t-butyl-3-indolyl group.

Examples of the aralkyl group described above include benzyl group, 1-phenylethyl group, 2-phenylethyl group, 1-phenylisopropyl group, 2-phenylisopropyl group, phenyl-t-butyl group, α-naphthylmethyl group, 1-α-naphthylethyl group, 2-α-naphthylethyl group, 1-αnaphthylisopropyl group, 2-α-naphthylisopropyl group, β-naphthylmethyl group, 1-β-naphthylethyl group, 2-β-naphthylethyl group, 1-β-naphthylisopropyl group, 2-β-naphthylisopropyl group, 1-pyrrolylmethyl group, 2-(1-pyrrolyl)ethyl group, p-methylbenzyl group, m-methylbenzyl group, o-methylbenzyl group, p-chlorobenzyl group, m-chlorobenzyl group, o-chlorobenzyl group, p-bromobenzyl group, m-bromobenzyl group, o-bromobenzyl group, p-iodobenzyl group, m-iodobenzyl group, o-iodobenzyl group, p-hydroxybenzyl group, m-hydroxybenzyl group, o-hydroxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenylisopropyl group and 1-chloro-2-phenylisopropyl group.

The aryloxyl group described above is represented by - OZ. Examples of the group represented by Z include phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenyl group, 3-biphenyl group, 4-biphenyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenyl-yl group, 4"-t-butyl- p-terphenyl-4-yl group, 2-pyrrolyl group, 3-pyrrolyl group, pyradinyl group, 2-pyridinyl group, 3-pyridinyl group, 4-pyridinyl group, 2-indolyl group, 3-indolyl group, 4-indolyl group, 5-indolyl group, 6-indolyl group, 7-indolyl group, 1-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzo- furanyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxanyl group, 5-quinoxanyl group, 6-quinoxanyl group, 1-carbazolyl group, 2-carbazolyl group, 3-carbazolyl group, 4-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiazinyl group, 2-phenothiazinyl group, 3-phenothiazinyl group, 4-phenothiazinyl group, 1-phenoxazinyl group, 2-phenoxazinyl group, 3-phenoxazinyl group, 4-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methyl-pyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group and 4-t-butyl-3-indolyl group.

The alkoxycarbonyl group described above is represented by - COOY. Examples of the group represented by Y include methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxy-isopropyl group, 2,3-dihydroxy-t- butyl group, 1,2,3-trihydroxypropyl group, chloromethyl group, 1-chloroethyl group, 2-chloroethyl group, 2-chloroisobutyl group, 1,2-dichloroethyl group, 1,3-dichlorolsopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-dilodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group and 1,2,3-trinitropropyl group.

The foregoing substituents may bond each other to form a ring. Examples of a divalent group formed by the bonding include tetramethylene group, pentamethylene group, hexamethylene group, diphenylmethan-2,2'-diyl group, diphenylethan-3,3'-diyl group and diphenylpropan-4,4'-yl group.

Specific structures of the material for organic EL devices comprising the compounds represented by the general formula (1) of the present invention include the following structures. Additionally, there are structures wherein Cz exists at the site corresponding Ar¹ or Ar², it is because Ar¹ and Ar² may contain Cz. Moreover, in the following structure, both the phenyl site and the thiophene site may be substituted with alkyl group or aryl group having 6 to 10 carbon atoms.

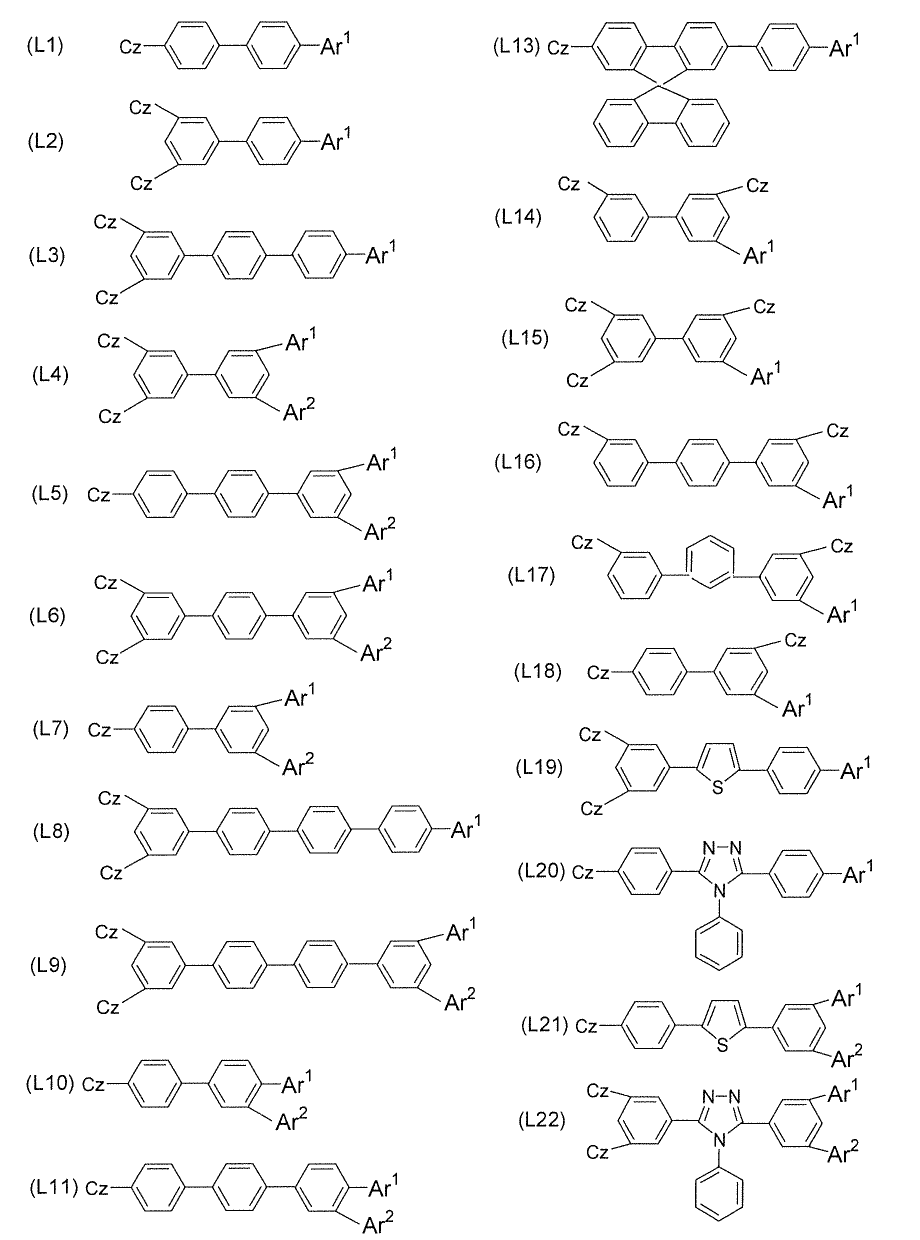

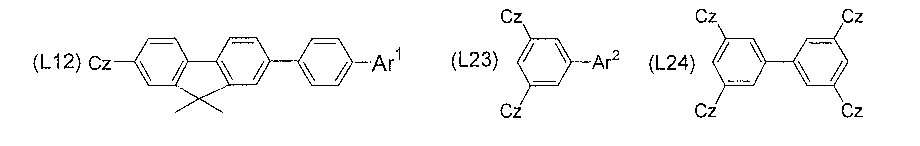

Specific examples of the material for organic EL devices comprising the compounds represented by the general formula (1) of the present invention include the following compounds, though not limited thereto.

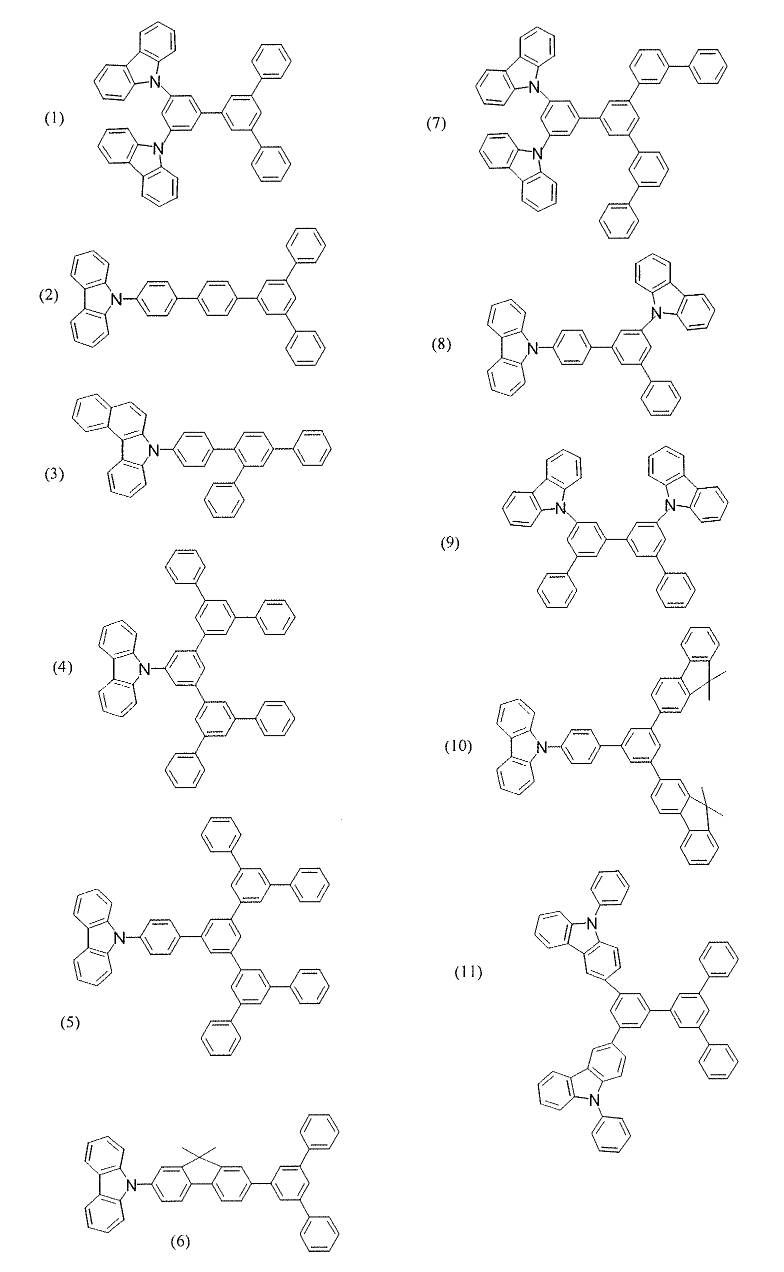

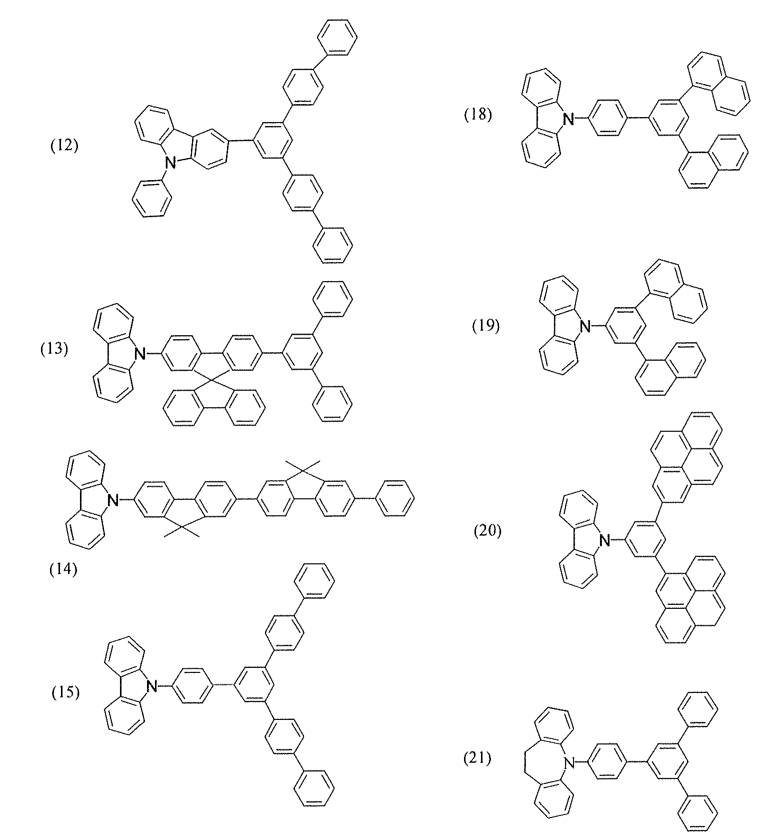

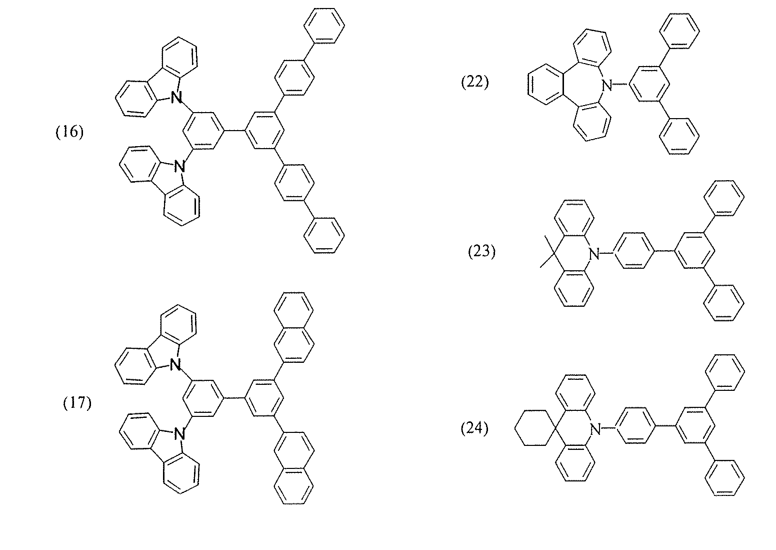

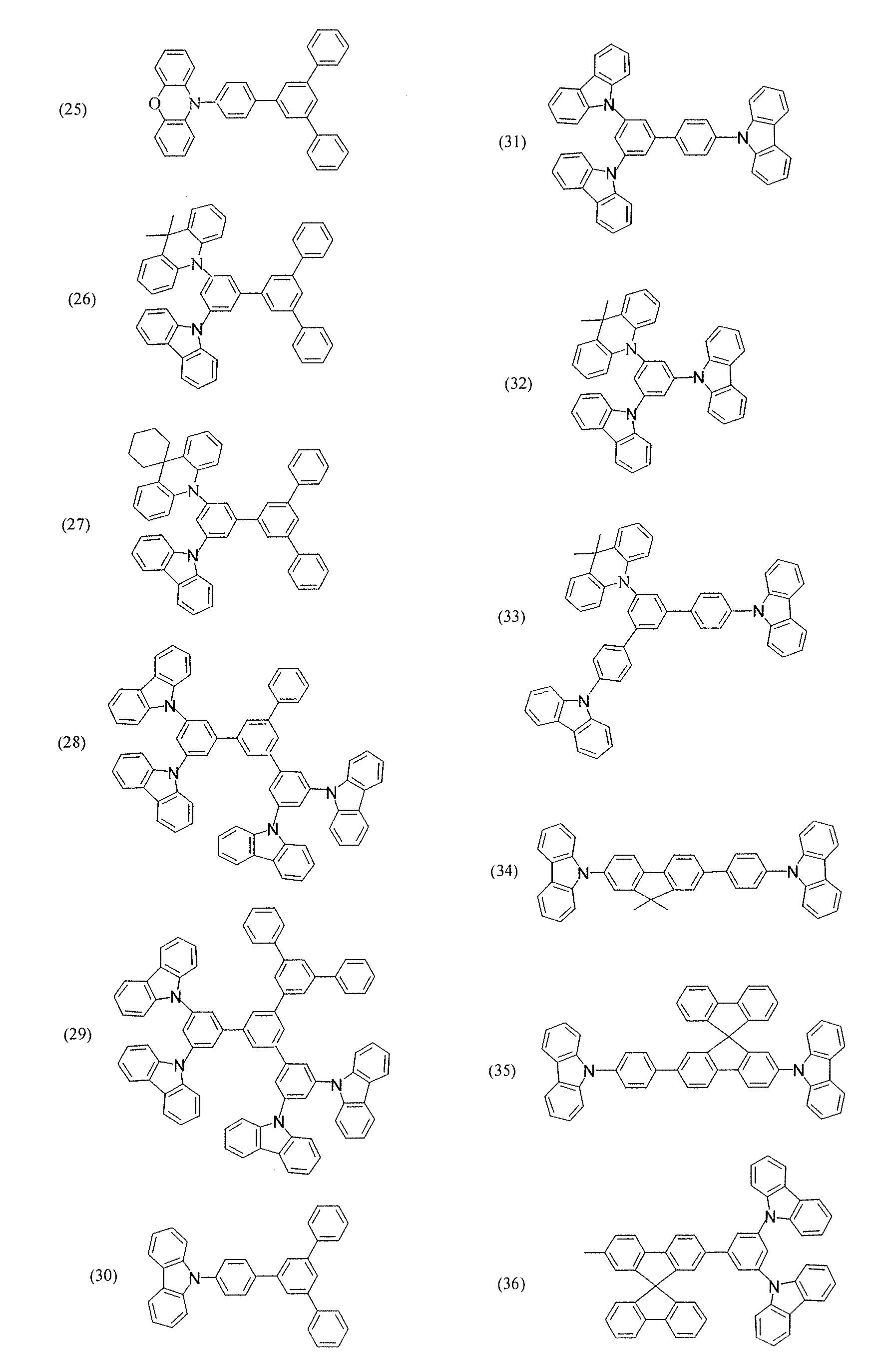

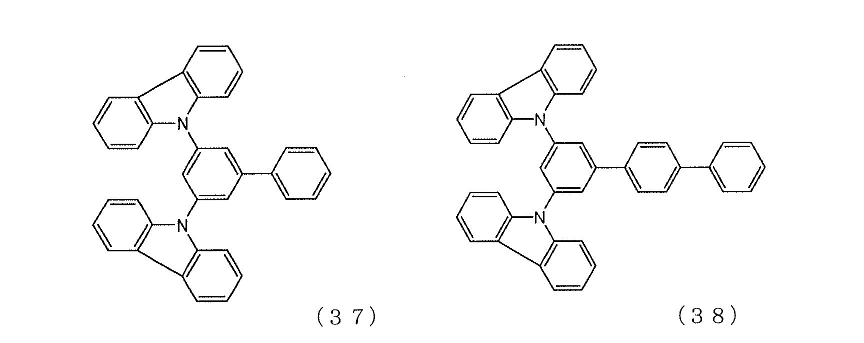

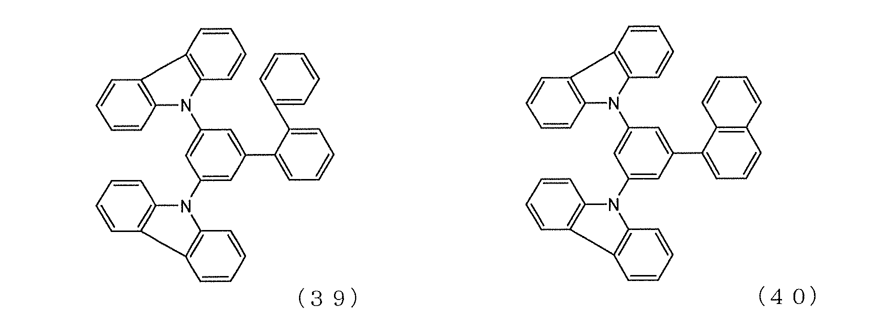

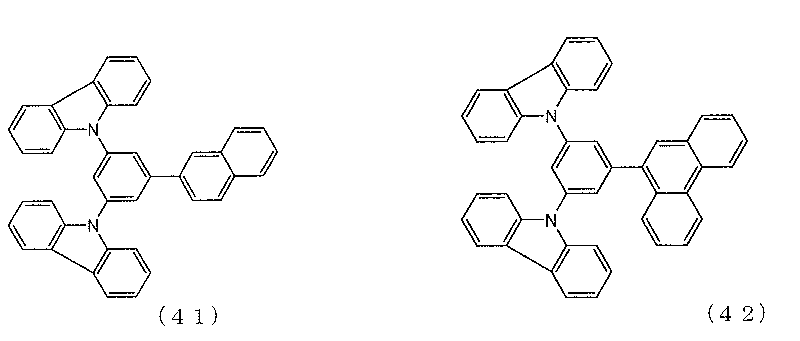

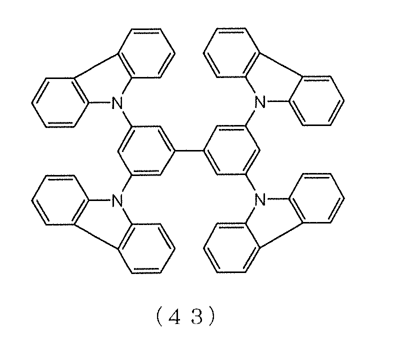

Further, the compound represented by general formula (1) is preferably a host material of the organic EL device, transports electric charges and has a glass transition temperature of 110 °C or higher. Furthermore, it is preferable that the compound has a triplet energy of 2.76 eV or greater because the compound has a capability of exciting a complex of green or red light emission. Still further, because the compound has a glass transition temperature of 110 °C or higher, and because it is possible that the compound has a triplet energy of 2.82 eV or greater, also, 2.85 eV or greater, the device will be superior in high-temperature storage and an EL device of green light emission with an enhanced efficiency of light emission relative to CBP may be expected. Additionally, the triplet energy is particularly preferable to be within a range of from 2.82 to 2.92 eV in order to excite the complex of green or red light emission. When the triplet energy exceeds 2.92 eV, the efficiency of light emission may be not enhanced.

Next, the organic EL device of the present invention will be explained.

The organic EL device of the present invention comprises a cathode, an anode and one or more organic thin film layers having at least a light emitting layer which are sandwiched between the cathode and the anode, wherein the organic thin film layers comprises at least one layer containing the material for organic EL devices in accordance with the present invention.

Typical examples of the construction of the organic EL device of the multi-layer type include an anode / a hole transporting layer (a hole injecting layer) / a light emitting layer / a cathod; an anode / a light emitting layer / an electron transporting layer (an electron injecting layer) / a cathode; an anode / a hole transporting layer (a hole injecting layer) / a light emitting layer / an electron transporting layer (an electron injecting layer) / a cathode; an anode / a hole transporting layer (a hole injecting layer) / a light emitting layer / a hole barrier layer / an electron transporting layer (an electron injecting layer) / a cathode; etc.

It is preferable that the light emitting layer in the organic EL device of the present invention comprises a host material and a phosphorescent material.

As the phosphorescent material, iridium complexes, osmium complexes and platinum complexes are preferable, iridium complexes and platinum complexes are more preferable, and iridium complexes in the form of ortho metal are most preferable each since the quantum yield of phosphorescence is great and the external quantum efficiency of the light emitting device can be further increased respectively. As for the form of the complex, metal complexes, compounds represented by the following general formulae (2) to (4) are preferable and compounds represented by general formulae (2) and (3) are more preferable.

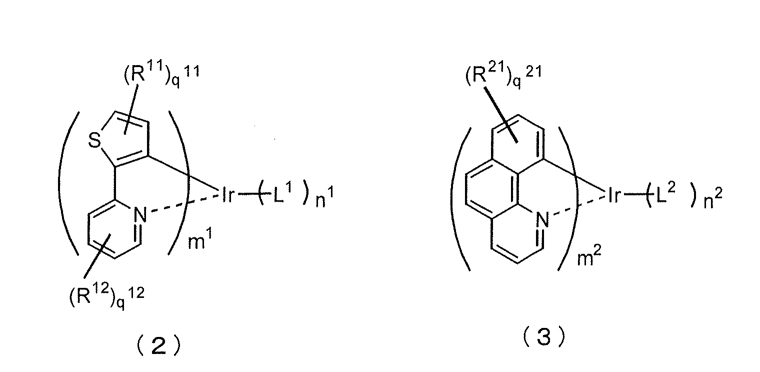

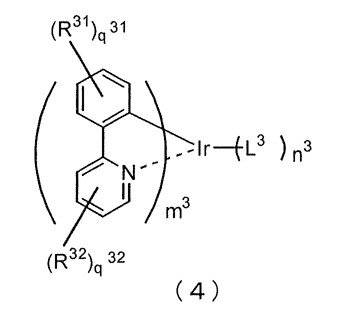

In general formula (2), R¹¹ and R¹² each independently represents alkyl group, aryl group, alkyl fluoride group or aryl fluoride group. It is preferable that they each independently represent alkyl group, aryl group or alkyl fluoride group. It is more preferable that they each independently represent alkyl group or alkyl fluoride group. q¹¹ represents an integer of 0 to 2, while 0 and 1 are preferable and 0 is more preferable. q¹² represents an integer of 0 to 4, while 0 and 1 are preferable and 0 is more preferable. When there are 2 or more of q¹¹ or q¹², the plural of q¹¹ or q¹² may be the same with or different from each other, and may bond to form a condensed ring.

L¹ represent a ligand. Examples of the ligand include ligands required to form the iridium metal complex in the form of ortho metal and so on, the ligands required to form the iridium metal complex in the form of ortho metal, heterocyclic ligands having nitrogen atom, diketone ligands, halogen ligands and bipyridil ligands being preferable. The ligands required to form the iridium metal complex in the form of ortho metal and bipyridil ligands are more preferable as the ligands. n¹ represents an integer of 0 to 5, while 0 is preferable. m¹ represents 1, 2 or 3, while 3 is preferable. With regard to a combination of numbers represented by n¹ and m¹, a combination that metal complexes represented by general formula (2) make neutral complexes.

R²¹, n², m² and L² in general formula (3) are each the same as above R¹¹, n¹, m¹ and L¹ respectively. q²¹ represents an integer of 0 to 8, while 0 is preferable. When q²¹ is 2 or more, they may be the same with or different from each other.

R³¹, R³², q³¹, q³², n³, m³ and L³ in general formula (4) are each the same as above R¹¹, R¹², q¹¹, q¹², n¹, m¹ and L¹.

The following iridium complexes are preferable as the foregoing phosphorescent material.

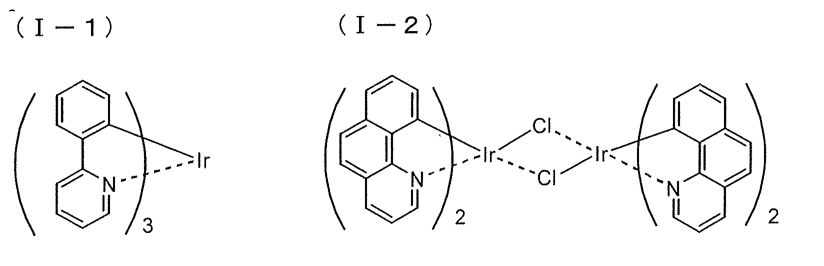

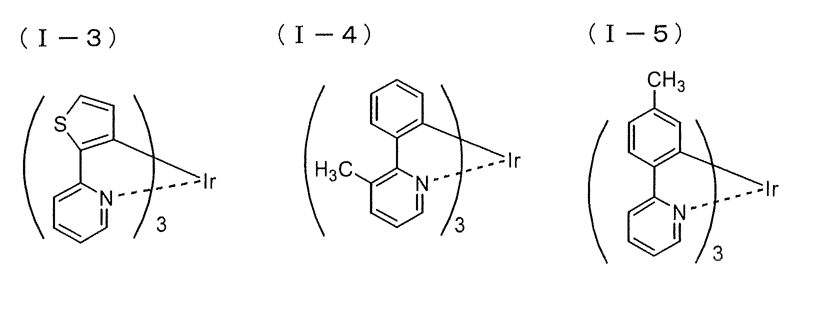

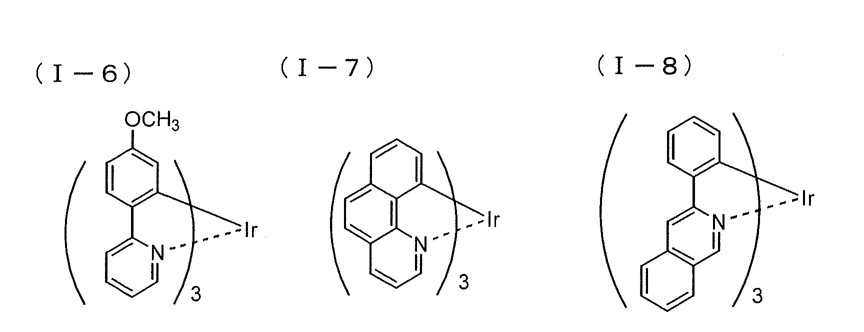

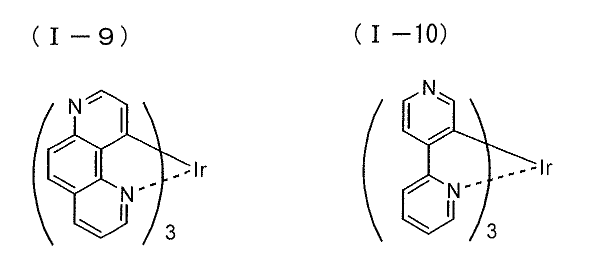

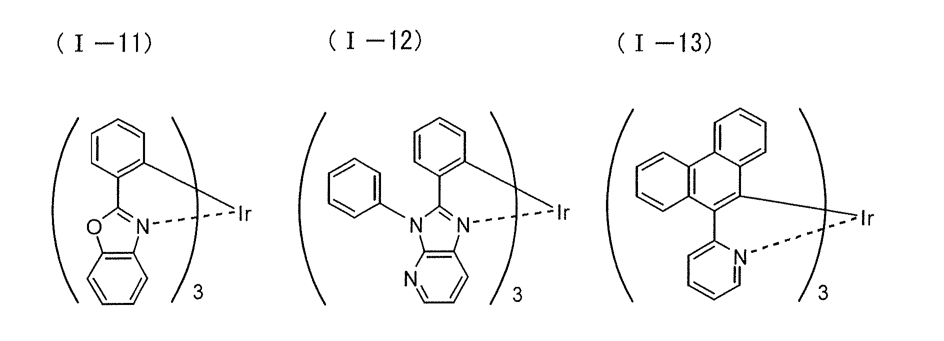

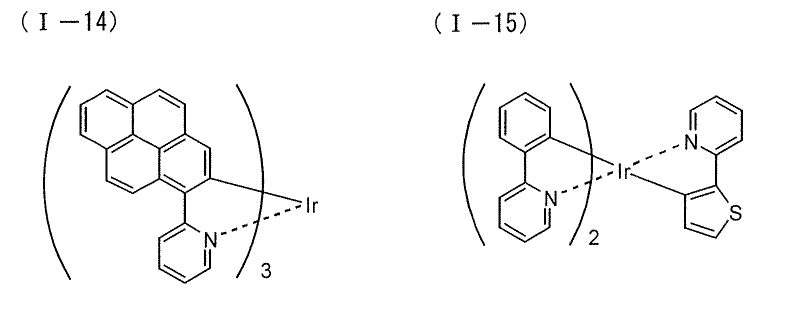

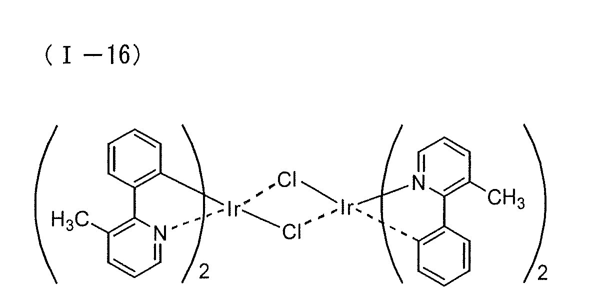

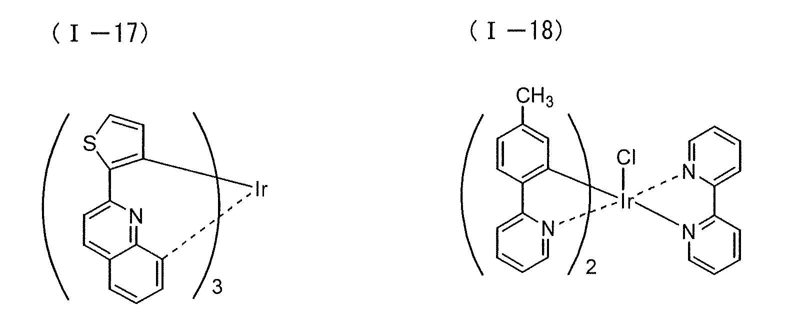

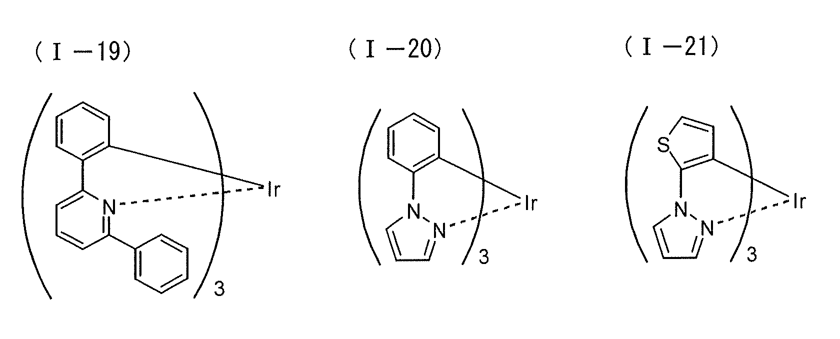

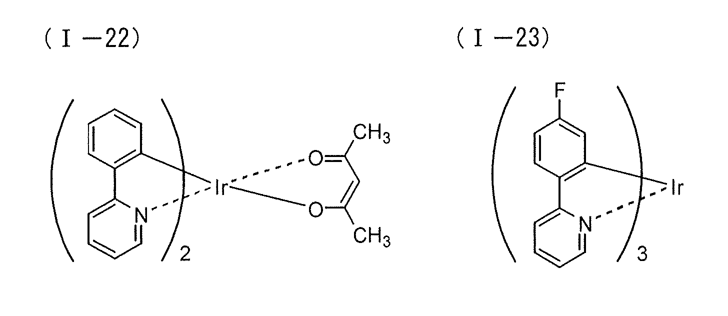

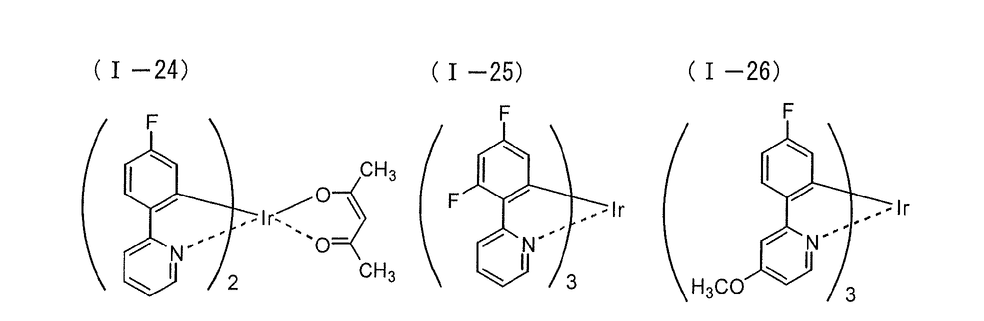

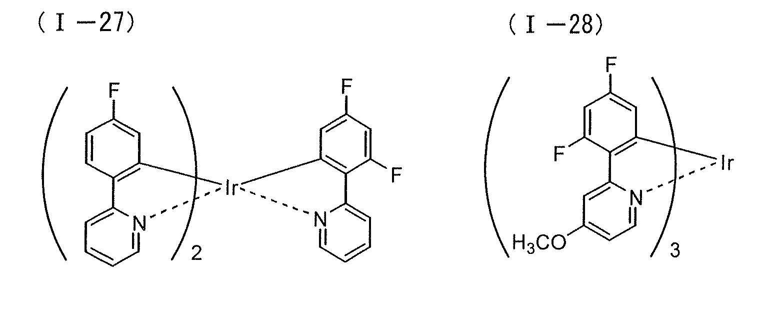

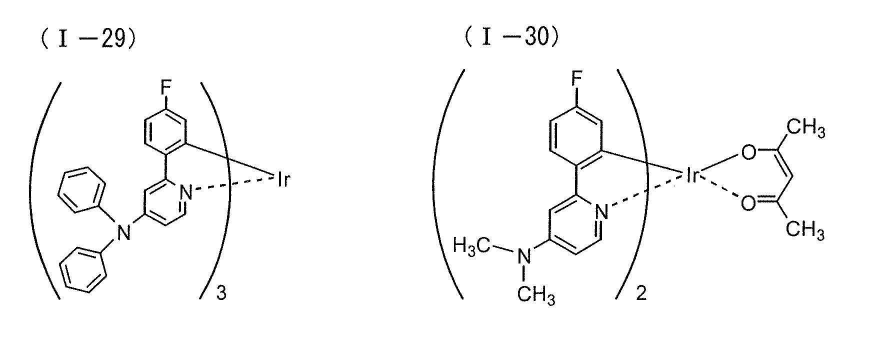

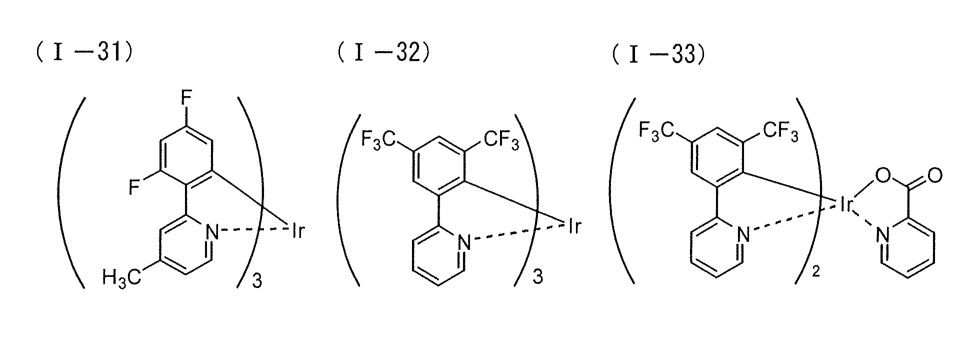

In the present invention, it is preferable that the reductive dopant is added in the interfacial zone between the cathode and the organic thin film layer of the organic EL device.

Examples of the reductive dopant include at least one compound selected from alkali metals, alkali metal complexes, alkali metal compounds, alkaline earth metals, alkaline earth metal complexes, alkaline earth metal compounds, rare earth metals, rare earth metal complexes and rare earth metal compounds.

Examples of the alkali metal include Na (the work function: 2.36 eV), K (the work function: 2.28 eV), Rb (the work function: 2.16 eV) and Cs (the work function: 1.95 eV). Alkali metals having a work function of 2.9 eV or smaller are preferable. Among these alkali metals, K, Rb and Cs are preferable, Rb and Cs are more preferable, and Cs is most preferable.

Examples of the alkaline earth metal include Ca (the work function: 2.9 eV), Sr (the work function: 2.0 to 2.5 eV) and Ba (the work function: 2.52 eV). Alkaline earth metals with a work function of 2.9 eV or smaller are preferable.

Examples of the rare earth metal include Sc, Y, Ce, Tb and Yb. Rare earth metals with a work function of 2.9 eV or smaller are preferable.

When the preferable metals among the above metals are used, the luminance of the emitted light and the life of the organic EL device can be increased by addition of the metals into the electron injecting layer in a relatively small amount since these metals have great reducing ability.

Examples of the alkali metal compound described above include alkali metal oxides such as Li₂O, Cₛ₂O and K₂O and alkali metal halides such as LiF, NaF, CsF and KF. Among these compounds, alkali metal oxides and alkali metal fluorides such as LiF, Li₂O and NaF are preferable.

Examples of the alkaline earth metal compound described above include BaO, SrO, CaO and mixtures thereof such as BaₓSr₁₋ₓO (O<x<1) and Baₓca₁₋ₓO (O<x<1). Among these compounds, BaO, SrO and CaO are preferable.

Examples of the rare earth metal compound described above include YbF₃, ScF₃, ScO₃, Y₂O₃, Ce₂O₃, GdF₃ and TbF₃. Among these compounds, YbF₃, ScF₃ and TbF₃ are preferable.

The alkali metal complex, the alkaline earth metal complex and the rare earth metal complex are not particularly limited as long as the complexes contain at least one of the alkali metal ions, the alkaline earth metal ions and rare earth metal ions, respectively, as the metal ion. As the ligand, quinolinol, benzoquinolinol, acridinol, phenanthridinol, hydroxyphenyloxazole, hydroxyphenylthiazole, hydroxydiaryloxadiazoles, hydroxydiarylthiadiazoles, hydroxyphenylpyridine, hydroxyphenylbenzimidazole, hydroxybenzotriazole, hydroxyfulvorane, bipyridyl, phenanthroline, phthalocyanine, porphyrin, cyclopentadiene, β-diketones, azomethines and derivatives of these compounds are preferable. However, the ligand is not limited to the ligands described above.

As for the addition form of the reductive dopant, it is preferable that the reductive dopant is added in a manner such that a layer or islands are formed in the interfacial zone described above. As the process for adding the reductive dopant, it is preferable that an organic material which is the light emitting material or the electron injecting material forming the interfacial zone is vaporized while the reductive dopant is simultaneously vapor deposited in accordance with the resistance heating deposition method so that the reductive dopant is dispersed in the organic material. The concentration of the dispersion expressed as the ratio of the amounts by mole of the organic substance to the reductive dopant is in the range of 100:1 to 1:100 and preferably in the range of 5:1 to 1:5.

When the reductive dopant is added to form a layer, the reductive dopant alone is vapor deposited in accordance with the resistance heating deposition method to form a layer preferably having a thickness of 0.1 to 15 nm after a layer of the organic material such as the light emitting material and the electron injecting material is formed as the interfacial zone.

When the reductive dopant is added to form islands, the reductive dopant alone is vapor deposited in accordance with the resistance heating deposition method to form islands preferably having a thickness of 0.1 to 15 nm after islands of the organic material such as the light emitting material and the electron injecting material were formed as the interfacial zone.

It is preferable that the relative amounts by mole of the main component and the reductive dopant in the electron injecting layer of the organic EL device of the present invention is in the range of 5:1 to 1:5 and more preferably in the range of 2:1 to 1:2.

It is preferable that the organic EL device of the present invention has an electron injecting layer between the light emitting layer and the cathode and that the electron injecting layer comprises a derivative of cyclic compound having nitrogen atom as a main component.

An aromatic heterocyclic compound having at least one hetero atom in its molecular is preferably employed as the electron transporting material used in the electron injecting layer, the derivative of cyclic compound having nitrogen atom being particularly preferable. A preferable specific compound among the derivative of cyclic compound having nitrogen atom has an azole backbone structure which is five-memberred ring. The aromatic heterocyclic compound has 2 or more atoms except carbon atom and hydrogen atom among basic backbone structure, and it may be a single ring or a condensed ring. The derivative of cyclic compound having nitrogen atom preferably has one or more atoms selected from nitrogen atom, oxygen atom and sulfur atom, together with the one nitrogen atom, and an aromatic heterocyclic compound having 2 or more nitrogen atoms among its backbone structure being more preferable. The hetero atom may exist at condensing location or at non-condensing location. Preferable examples of the heterociclic backbone structure having 2 or more hetero atoms include pyrazole, imidazole, pyrazine, pyrimidine, indazole, purine, phthalazine, naphthyridine, quinoxaline, quinazoline, cinnoline, pteridine, perimidin, phenanthroline, pyrrolo glyoxaline, pyrrolo triazole, pyrazolo glyoxaline, pyrazolo triazole, pyrazolopyrimidine, pyrazolo triazine, imidazo glyoxaline, imidazo pyridazine, imidazopyridine, imidazo pyrazine, triazolopyridine, benzimidazole, naphth glyoxaline, benz oxazole, naphth oxazole, benzothiazole, naphth thiazole, benzotriazol, tetrazaindene, triazine, etc.

Among the above description, a compound having condensed azole backbone structure such as imidazopyridazine, imidazopyridine, imidazo pyrazine, benzimidazole, etc., or a compound having triazine backbone structure is preferable as the electron transportable host materials, and condensed imidazopyridine being more preferable.

Preferable compound having azole backbone structure is represented by the following general formula (5): 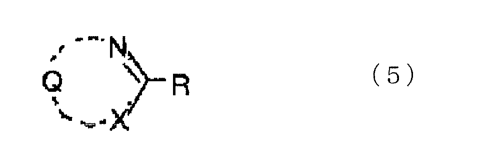 wherein R represents aromatic group; X represents oxygen, sulfur or N-Ra (Ra represents hydrogen atom, an aliphatic hydrocarbon group, aryl group or hetero ring group); Q represents an atom group necessary to form the hetero ring by bonding with N and X; further, R and X or R and Q may bond to form a ring if possible.

The following compounds are preferable as the foregoing derivative of cyclic compound having nitrogen atom.

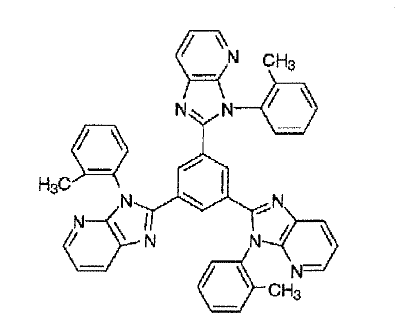

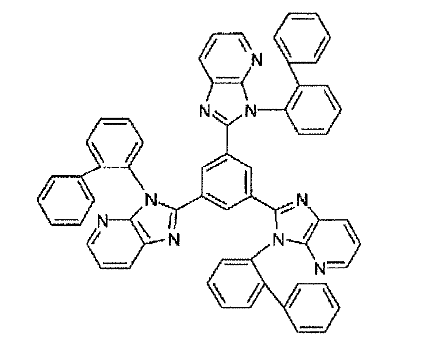

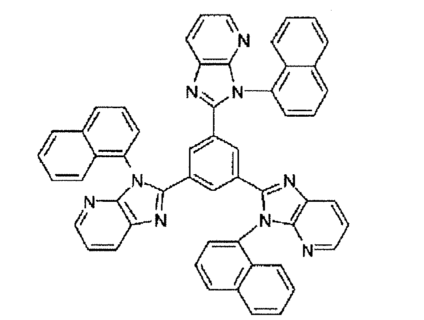

Furthermore, it is preferable that an electric insulator or a semiconductor is used as an inorganic compound in addition to the derivative of cyclic compound having nitrogen atom as a component of the electron injecting layer. The electron injecting layer comprising the electric insulator or semiconductor enables to effectively prevent a leak of electric current and to improve the electron injection property.

With regard to the electric insulator, an employment of at least one or more kinds of metal compound selected from the group consisting of alkaline metal chalcogenide, alkaline earth metal chalcogenide, halide of alkaline metal and halide of alkaline earth metal is preferable. When the electron injecting layer comprises these alkali metal chalcogenide or so, it is preferable because the electron injection property is further improved. Preferable examples of the alkali metal chalcogenide include Li₂O, LiO, Na₂S, Na₂Se and NaO. Preferable examples of the alkaline earth metal chalcogenide include CaO, BaO, SrO, BeO, BaS and CaSe. Preferable examples of the alkali metal halide include LiF, NaF, KF, LiCl, KCl and NaCl. Preferable examples of the alkaline earth metal halide include fluorides such as CaF₂, BaF₂, SrF₂, MgF₂ and BeF₂ and halides other than the fluorides.

Examples of the semiconductor include oxides, nitrides and oxide nitrides containing at least one element selected from Ba, Ca, Sr, Yb, Al, Ga, In, Li, Na, Cd, Mg, Si, Ta, Sb and Zn, which are used singly or in combination of two or more. It is preferable that the inorganic compound constituting the electron injection layer is in the form of a fine crystalline or amorphous insulating thin film. When the electron injection layer is constituted with the above inorganic compound, a more uniform thin film can be formed and defective pixels such as dark spots can be decreased. Examples of the inorganic compound include the alkali metal chalcogenides, the alkaline earth metal chalcogenides, the alkali metal halides and the alkaline earth metal halides which are described above.

Further, it is also preferable that the electron injecting layer in the present invention contains the above-mentioned reductive dopant.

It is preferable that the organic EL device of the present invention has a hole transporting layer between the light emitting layer and the anode and that the hole transporting layer comprises an arylamine derivative as a main component. Further, it is preferable that the triplet energy of the hole transporting material in the hole transporting layer falls within a range of from 2.52 to 3.7 eV, more desirably from 2.8 to 3.7 eV. An employment of the hole transporting material having the above triplet energy range enables to prevent quenching an excitation energy of the light emitting layer.

The above hole transporting material is preferably represented by the following general formulae (6) and (7): 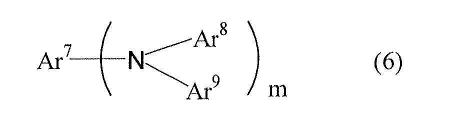 wherein Ar⁷ represents an aromatic group having 6 to 40 carbon atoms, Ar⁸ and Ar⁹ each independently represents hydrogen atom or an aromatic group having 6 to 40 carbon atoms respectively, and m represents an integer of 1 to 6. 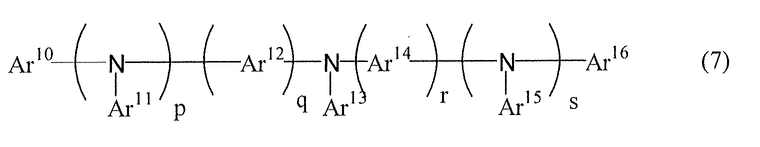 wherein Ar¹⁰ and Ar¹⁶ each represents an aromatic group having 6 to 40 carbon atoms, Ar¹¹ to Ar¹⁵ each independently represents hydrogen atom or an aromatic group having 6 to 40 carbon atoms respectively, and condensation numbers p, q, r and s are each 0 or 1 respectively.

Among the aromatic group having 6 to 40 carbon atoms in the above general formulae (6) and (7), preferable examples of aryl group having 5 to 40 nuclear atoms include phenyl, naphthyl, anthranil, phenanthryl, pyrenyl, coronyl, biphenyl, terphenyl, pyrrolyl, furanyl, thiophenyl, benz thiophenyl, oxadiazolyl, diphenyl anthranil, indolyl, carbazolyl, pyridyl, benz quinolyl, fluoranthenyl, acenaphtho fluoranthenyl, etc. Further, preferable examples of arylene group having 5 to 40 nuclear atoms include phenylene, naphthylene, anthranylene, phenanthrylene, pyrenylene, coronylene, biphenylene, terphenylene, pyrrolylene, franylene, thiophenylene, benz thiophenylene, oxadiazolilane, diphenylanthranilane, indolilane, carbazolilane, pyridylene, benzoquinolilane, fluoranthenylene, acenaphthofluoranthenylene, etc. Additionally, the aromatic group having 6 to 40 carbon atoms may be further substituted with a substituent. Preferable examples of the substituent include alkyl group having 1 to 6 carbon atoms (e.g. ethyl group, methyl group, i-propyl group, n-propyl group, s-butyl group, t-butyl group, pentyl group, hexyl group, cyclopentyl group, cyclohexyl group, etc.), alkoxyl group having 1 to 6 carbon atoms (e.g. ethoxy group, methoxy group, i-propoxy group, n-propoxy group, s-butoxy group, t-butoxy group, pentoxy group, hexyloxy group, cyclopentoxy group, cyclohexyloxy group, etc.), aryl group having 5 to 40 nuclear carbon atoms, amino group substituted with aryl group having 5 to 40 nuclear carbon atoms, ester group having 5 to 40 nuclear carbon atoms, ester group with alkyl group having 1 to 6 carbon atoms, cyano group, nitro group and halogen atom.

Preferable examples of the hole transporting material having triplet energy of 2.8 eV or greater is represented by the following general formulae (8) to (10): 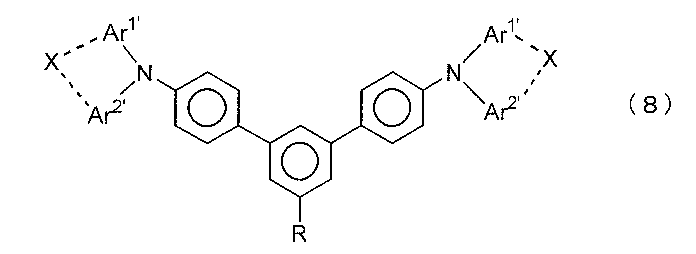 wherein Ar¹' and Ar²' each independently represents alkyl group having 1 to 6 carbon atoms or aryl group having 6 to 18 nuclear carbon atoms which may be substituted with alkoxyl group or phenyl group; R represents alkyl group having 4 to 6 carbon atoms,alkoxyl group having 4 to 6 carbon atoms or aryl group having 6 to 18 nuclear carbon atoms; and X represents a single bond or a coupling group expressed with -O- or -S-, which may be present or absent. 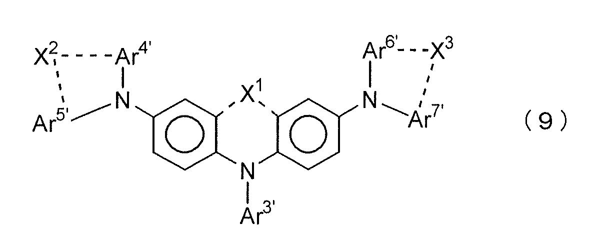 wherein Ar³' represents a substituted or unsubstituted aryl group having 6 to 18 nuclear carbon atoms; Ar⁴' to Ar⁷' each independently represents a substituted or unsubstituted arylene group having 6 to 18 nuclear carbon atoms; X¹ represents a single bond or a coupling group expressed with -O-, -S-, -(CH₂)ₙ- (n is an integer of 1 to 6) or -C(CH₃)₂-; X¹ being present or absent; X² and X³ each independently represents a single bond or a coupling group expressed with -O-, -S-, -(CH₂)n- (n is an integer of 1 to 6) or -C(CH₃)₂-; and X² and X³ may be the same with or different from each other.

Specific examples of each groups and substituents represented by Ar¹' to Ar⁷', R, X and X¹ to X³ in general formulae (8) and (9) are almost the same as the examples of the foregoing Cz and Ar¹ to Ar⁶. 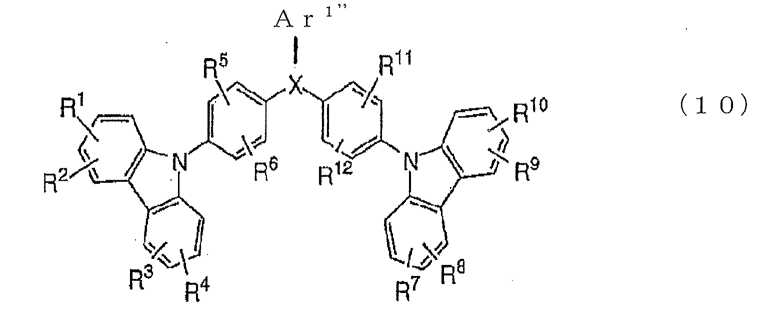 wherein R¹ to R¹² each independently represents hydrogen atom, halogen atom, alkyl group, aralkyl group, alkenyl group, cyano group, amino group, acyl group, alkoxycarbonyl group, carboxyl group, alkoxy group, alkylamino group, aralkyl amino group, haloalkyl group, hydroxy group, aryloxy group, aromatic hydrocarbon ring group which may have substituent or aromatic heterocyclic group which may have substituent, and adjacent substituents of R¹ and R², R³ and R⁴, R⁵ and R⁶, R⁷ and R⁸, R⁹ and R¹⁰, and R¹¹ and R¹² each may bond to form a ring; X represents trivalent coupling group represented by the structure below: 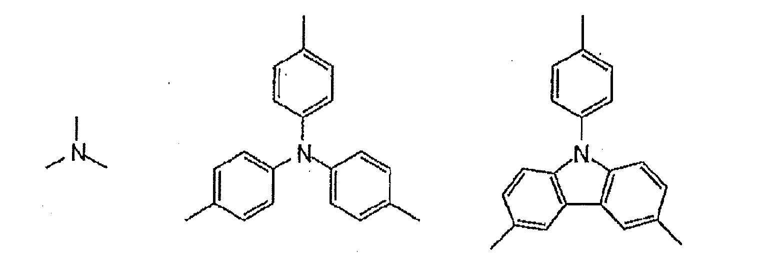 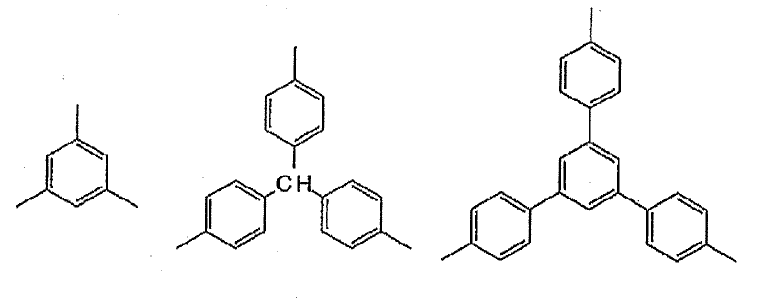 and Ar¹" represents aromatic hydrocarbon ring group which may have substituent, aromatic heterocyclic group which may have substituent or is represented by the following general formula (11): 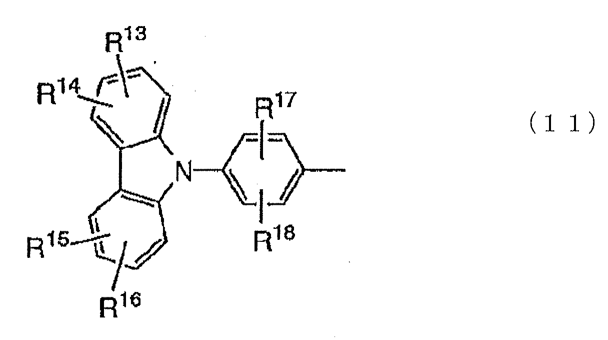 wherein R¹³ to R¹⁸ each independently represents hydrogen atom, halogen atom, alkyl group, aralkyl group, alkenyl group, cyano group, amino group, acyl group, alkoxycarbonyl group, carboxyl group, alkoxy group, alkylamino group, aralkyl amino group, haloalkyl group, hydroxy group, aryloxy group, aromatic hydrocarbon ring group which may have substituent or aromatic heterocyclic group which may have substituent, and adjacent substituents of R¹³ and R¹⁴, R¹⁵ and R¹⁶, and R¹⁷ and R¹⁸ each may bond to form a ring.

Specific examples of each groups and substituents represented by Ar¹", R¹ to R¹⁸ in general formulae (10) are almost the same as the examples of the foregoing Cz and Ar¹ to Ar⁶.

The anode of the organic EL device plays the role of injecting holes into the hole transporting layer or the light emitting layer. It is effective that the anode has a work function of 4.5 eV or greater. Examples of the material of the anode used in the present invention include indium tin oxide alloys (ITO), tin oxides (NESA), gold, silver, platinum and copper. As the cathode, a material having a small work function is preferable so that electrons can be injected into the electron injection layer or the light emitting layer. The material of the cathode is not particularly limited. Examples of the material of the cathode include indium, aluminum, magnesium, magnesium-indium alloys, magnesium-aluminum alloys, aluminum-lithium alloys, aluminum-scandium-lithium alloys and magnesium-silver alloys.

The process for forming the layers in the organic EL device of the present invention is not particularly limited. A conventional process such as the vacuum vapor deposition process and the spin coating process can be used. The organic thin film layer used in the organic EL device of the present invention can be formed in accordance with the vacuum vapor deposition process, the molecular beam epitaxy process (the MBE process) or, using a solution prepared by dissolving the compound represented by the foregoing general formula (1) into a solvent, in accordance with a conventional coating process such as the dipping process, the spin coating process, the casting process, the bar coating process and the roller coating process.

The thickness of each layer in the organic thin film layer in the organic EL device of the present invention is not particularly limited. In general, an excessively thin layer tends to have defects such as pin holes, and an excessively thick layer requires a high applied voltage results in decreasing the efficiency. Therefore, a thickness within the range of several nanometers to 1 *µ*m is preferable.

Examples of a synthesizing method for the compound represented by general formula (1) include a method of reacting the compound represented by general formula (a) with the compound represented general formula (b) in an organic solvent under the existence of base and with the use of a palladium catalyst, a method of reacting the compound represented by general formula (c) with the compound represented general formula (d) in an organic solvent under the existence of base and with the use of a palladium catalyst, etc. 1, m, n, p and q in the following general formulae (a) to (d) each independently represents an integer appropriately selected to satisfy general formula (1).

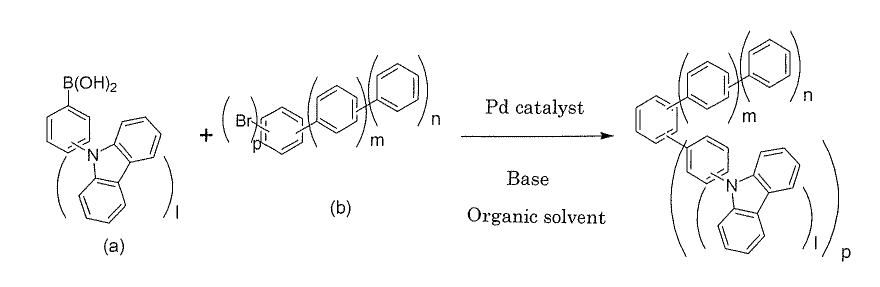

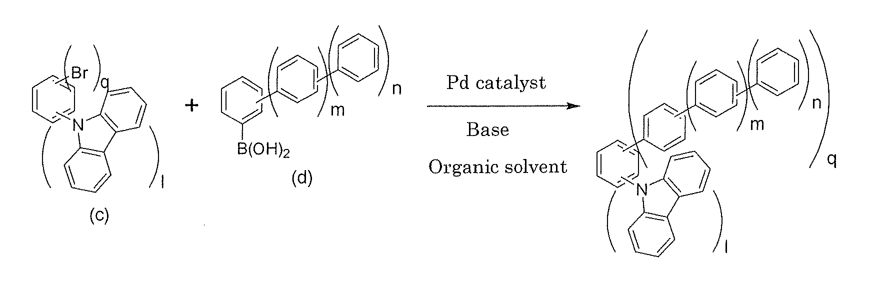

Any solvent which does not participate in the above reaction may be employable as the organic solvent such as, for example, aromatic hydrocarbon-based solvent like benzene, toluene, xylene, and so on or ether-based solvent like 1,2-dimethoxyethane, tetrahydrofuran, etc.

Typical examples of the base employed for the above reaction include inorganic bases such as sodium carbonate, potassium carbonate, sodium hydrogencarbonate, potassium hydrogencarbonate, sodium hydroxide, potassium hydroxide, etc., organic bases such as triethylamine, pyridine, etc. Among the above examples, sodium carbonate is preferable. Further, water may coexist in order to dissolve the inorganic base.

Typical examples of the palladium catalyst include tetrakis (triphenylphosphine) palladium, dichlorobis (triphenylphosphine) palladium, palladium acetate-triphenylphosphine, etc. Preferable examples are tetrakis (triphenylphosphine) palladium, etc.

The present invention will be described more specifically with reference to examples and synthesis examples in the following. However, the present invention is not limited to the examples.

### EXAMPLE

The triplet energy gap and the singlet energy of a compound were measured in accordance with the following methods.

### (1) Measurement of the triplet energy gap

The lowest excited triplet energy level T1 was measured. The phosphorescence spectrum of a sample was measured (10 µ moles/liter EPA solution (diethyl ether : isopentane : ethanol= 5:5:2 by volume); 77K; a quartz cell; FLUOROLOG II manufactured by SPEX Company). A tangent was drawn to the increasing line at the short wavelength side of the phosphorescence spectrum, and the wavelength (the end of light emission) at the intersection of the tangent and the abscissa was obtained. The obtained wavelength was converted into the energy.

### (2) Measurement of the singlet energy gap

The excited singlet energy was measured. Using a toluene solution (10⁻⁵ moles/liter) of a sample, the absorption spectrum was obtained by a spectrometer for absorption of ultraviolet and visible light manufactured by HITACHI Co. Ltd. A tangent was drawn to the increasing line at the long wavelength side of the spectrum, and the wavelength (the end of absorption) at the intersection of the tangent and the abscissa was obtained. The obtained wavelength was converted into the energy.

### Synthesis Example 1 (Synthesis of Compound (30))

The route of synthesis of Compound (30) is shown in the following.

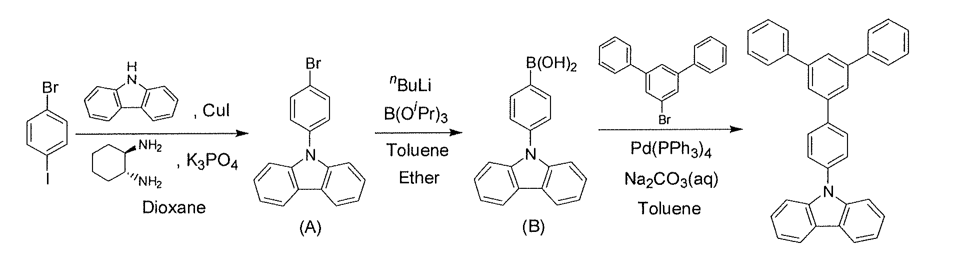

### (1) Synthesis of intermediate compound (A)

Suspending 25.4 g (90 mmol) of 4-bromo iodobenzene , 10.0 g (60 mmol) carbazole, 0.1 g (0.5 mmol) of copper iodide and 26.7 g (126 mmol) of potassium phosphate into 70 milliliter of 1,4-dioxane, and adding 0.7 milliliter (6 mmol) of trans-1,2-cyclohexane diamine, the resultant solution was refluxed under heating and under the atmosphere of Argon gas for 15 hours. The reacted solution was cooled to the room temperature. Methylene chloride and water were added to the solution, and the resultant mixed solution was separated into two layers. The organic layer was washed with a 5 % aqueous solution of hydrochloric acid and water successively, and dried with anhydrous sodium sulfate. After the organic solvent was removed by distillation under a reduced pressure, 50 milliliter of ethanol was added to the residue. The formed crystals were separated by filtration and washed with ethanol and normal hexane successively, and 17.8 g (the yield: 92 %) of intermediate compound (A) was obtained.

### (2) Synthesis of intermediate compound (B)

Dissolving 8.1 g (25 mmole) of intermediate product (A) into 50 milliliter of toluene and 50 milliliter of ether, 21 milliliter (32 mmole) of a hexane solution of n-butyllithium (1.6 M) was added to the resultant solution under the atmosphere of argon gas and at the temperature of - 40° C, and the obtained solution was stirred at the temperature of -40 to 0 °C for 1 hour. After the reaction solution was cooled to -70 °C, a solution obtained by diluting 17 milliliter (74 mmole) of triisopropyl borate with 25 milliliter of ether was added dropwise. After the resultant solution was stirred at -70° C for 1 hour, the temperature was elevated to the room temperature, and the solution was stirred for 6 hours. To the resultant reaction solution, 70 milliliter of a 5 % hydrochloric acid was added dropwise, and the obtained solution was stirred at the room temperature for 45 hours. After the reacted solution was separated into two layers, the organic layer was washed with a saturated solution of sodium chloride and dried with anhydrous sodium sulfate. The organic solvent was removed by distillation under a reduced pressure until the amount of the organic solvent decreased to about one fifth of the original amount. The formed crystals were separated by filtration and washed with a mixed solvent of toluene and n-hexane and n-hexane, successively, and 4.0 g of intermediate product (B) was obtained (yield: 56 %).

### (3) Synthesis of aimed compound (30)

Suspending 2.0 g (7.0 mmol) of the intermediate compound (B), 2.2 g (7.0 mmol) of bromo-3,5-diphenyl benzene and 0.16 g (0.14 mmol) of tetrakis (triphenylphosphine) palladium into 21 milliliter of toluene, and adding a solution dissolving 2.2 g (21 mmol) of sodium carbonate into 11 milliliter of water, the resultant solution was refluxed under heating and under the atmosphere of argon gas for 9 hours. After the reacted solution was separated into two layers, the organic layer was washed with a saturated solution of sodium chloride and dried with anhydrous sodium sulfate. The organic solvent was removed by distillation under a reduced pressure, and 12 milliliter of ethyl acetate was added to the residue. The formed crystals were separated by filtration and washed with ethyl acetate, and 2.6 g of crystals were obtained (yield: 78 %). It was confirmed in accordance with 90 MHz ¹H-NMR and Field Desorption Mass Spectrometry (FD-MS) that the obtained crystals were the aimed compound. The result of the measurement in accordance with FD-MS is shown in the following.
FDMS, calcd for C₃₆H₂₅N=471, found, m/z=471 (M⁺ ,100)

### Synthesis Example 2 (Synthesis of Compound (1))

The route of synthesis of Compound (1) is shown in the following.

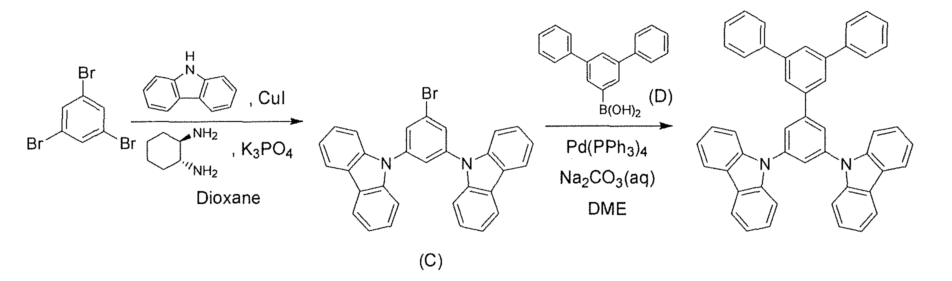

### (1) Synthesis of intermediate compound (C)

Suspending 5.0 g (16 mmol) of 1,3,5-tribromobenzene, 8.8 g (52 mmol) of arbazole, 0.3 g (1.6 mmol) of cuprous iodide and 13.8 g (65 mmol) of potassium phosphate into 50 milliliter of 1,4-dioxane, and adding 1.9 milliliter (16 mmol) of trans-1,2-cyclohexane diamine, the resultant solution was refluxed under heating and under the atmosphere of argon gas for 19 hours. The reacted solution was cooled to the room temperature. Methylene chloride and water were added to the solution, and the resultant mixture was separated into two layers. The organic layer was washed with water and dried with anhydrous sodium sulfate. After the organic solvent was removed by distillation under a reduced pressure until the amount of the organic solvent decreased to about one fifth of the original amount, the formed crystals were separated by filtration and washed with ethyl acetate. The obtained residue was purified in accordance with the silica gel column chromatography, and 1.8 g of intermediate product (C) were obtained (yield: 23 %).

### (2) Synthesis of intermediate compound (D)

Dissolving 10.0 g (32mmol) of bromo-3,5-diphenyl benzene into a solution of both toluene in an amount of 50 milliliter and ether in an amount of 50 milliliter, adding 27 milliliter (42 mmol) of normal butyllithium hexane solution (1.6M) under the atmosphere of argon gas and at the temperature of -16 to -42 °C, the resultant solution was stirred at the temperature of - 42 °C to 0 °C for 1 hour. After the reacted solution was cooled to -70 °C, a solution obtained by diluting 22 milliliter (97 mmole) of triisopropyl borate with 25 milliliter of ether was added dropwise. After the resultant solution was stirred at -70° C for 1 hour, the temperature was elevated to the room temperature, and the solution was stirred for 6 hours. To the resultant reaction solution, 70 milliliter of a 5 % hydrochloric acid was added dropwise, and the obtained solution was stirred at the room temperature for 45 hours. After the reacted solution was separated into two layers, the organic layer was washed with 3 % hydrochloric acid and a saturated solution of sodium chloride successively and dried with anhydrous sodium sulfate. The organic solvent was removed by distillation under a reduced pressure until the amount of the organic solvent decreased to about one fifth of the original amount. Then, adding 10 milliliter of normal hexane, formed crystals were separated by filtration and washed with a mixed solvent of toluene and n-hexane and n-hexane, successively, and 7.0 g of intermediate compound (D) was obtained (yield: 78 %).

### (3) Synthesis of aimed compound (1)

Suspending 1.8 g (3.6 mmol) of the intermediate compound (C), 0.99 g (3.6 mmol) of the intermediate compound (D) and 0.08 g (0.07 mmol) of tetrakis (triphenylphosphine) palladium into 22 milliliter of 1,2-dimethoxyethane, and adding a solution dissolving 1.1 g (11 mmol) of sodium carbonate into 5 milliliter of water, the resultant solution was refluxed under heating and under the atmosphere of argon gas for 9 hours. The reacted solution was cooled down to room temperature and precipitated crystals were separated by filtration, washed with water, methanol and ethyl acetate successively, resultantly obtaining 1.9 g of crude crystals. The crystals were purified by sublimation under reduced pressure, and 1.6 g of purified crystals was obtained (yield: 68 %).

It was confirmed in accordance with 90 MHz ¹H-NMR and FD-MS that the obtained crystals were the aimed compound. The result of the measurement in accordance with FD-MS is shown in the following.
FDMS, calcd for C₄₈H₃₂N₂= 636, found, m/z= 636(M⁺, 100)

### Synthesis Example 3 (Synthesis of Compound (4))

The route of synthesis of Compound (4) is shown in the following.

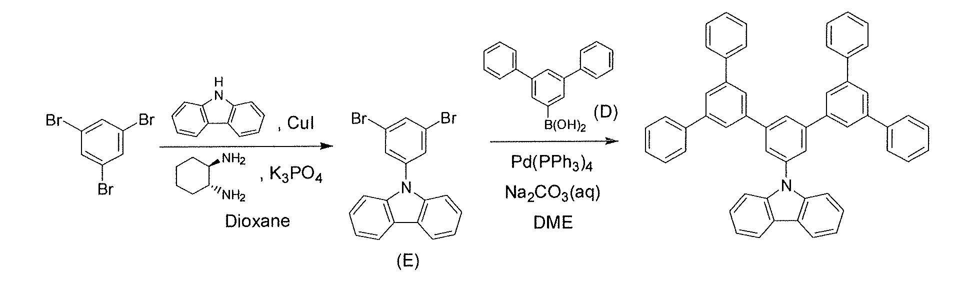

### (1) Synthesis of intermediate compound (E)

Suspending 5.0 g (16 mmol) of 1,3,5-tribromobenzene, 5.3 g (32 mmol) of carbazole, 0.3 g (1.6 mmol) of cuprous iodide and 13.8 g (65 mmol) of potassium phosphate into 50 milliliter of 1,4-dioxane, and adding 1.9 milliliter (16 mmol) of trans-1,2-cyclohexane diamine, the resultant solution was refluxed under heating and under the atmosphere of argon gas for 9 hours. The reacted solution was cooled to the room temperature. Methylene chloride and water were added to the solution, and the resultant mixture was separated into two layers. The organic layer was washed with water and dried with anhydrous sodium sulfate. After the organic solvent was removed by distillation under a reduced pressure until the amount of the organic solvent decreased to about 1 fifth of the original amount, the formed crystals were separated by filtration and washed with ethyl acetate. The obtained residue was purified in accordance with the silicagel column chromatography, and 2.0 g of intermediate product (E) was obtained (yield: 31 %).

### (2) Synthesis of aimed compound (4)

Suspending 1.8 g (4.5 mmol) of the intermediate compound (E), 2.5 g (3.6 mmol) of the intermediate compound (D) and 0.16 g (0.13 mmol) of tetrakis (triphenylphosphine) palladium into 27 milliliter of 1,2-dimethoxyethane, and adding a solution dissolving 2.9 g (11 mmol) of sodium carbonate into 14 milliliter of water, the resultant solution was refluxed under heating and under the atmosphere of argon gas for 18 hours. The reacted solution was cooled down to room temperature and precipitated crystals were separated by filtration, washed with a water, methanol and ethyl acetate successively, resultantly obtaining 3.3 g of crude crystals. The crystals were purified by sublimation under reduced pressure, and 2.9 g of purified crystals was obtained (yield: 92 %).

It was confirmed in accordance with 90 MHz ¹H-NMR and FD-MS that the obtained crystals were the aimed compound. The result of the measurement in accordance with FD-MS is shown in the following.
FDMS, calcd for C₅₄H₃₇N= 699, found, m/z=699 (M⁺, 100)

### Synthesis Example 4 (Synthesis of Compound (37))

### (1) Synthesis of intermediate compound (C)

Under the atmosphere of argon gas ventilation, 118 g of 1,3,5-tribromobenzene (available from TOKYO KASEI Co., Ltd.), 125 g of carbazole (available from Sigma-Aldrich Corporation), 7 g of copper iodide (available from Wako Pure Chemical Industries, Ltd.), 317 g of tri-potassium phosphate (available from Wako Pure Chemical Industries, Ltd.), 43 g of trans-1,2-cyclohexane diamine (available from TOKYO KASEI Co., Ltd.) and 1.2 liters of 1,4-dioxane (available from Wako Pure Chemical Industries, Ltd.) were placed into a flask with a capacity of 3 liters, and the mixed solution was stirred at the temperature of 104 °C for 15 hours.

After the reaction, the solution was naturally cooled down to room temperature, adding 1 liter of water, it was extracted by further adding 3 liters of methylene chloride. The extracted solution was dried with the use of anhydride magnesium sulfide, and then, condensed under reduced pressure. The resultant residue was filtered under reduced pressure, and a mother liquor was purified with the use of silicagel column chromatography thereby obtaining 92 g of 3,5-bis(carbazolyl-9-yl)-1-bromobenzene (Intermediate Compound (C)).

### (2) Synthesis of aimed compound (37)

Under the atmosphere of argon gas ventilation, an aqueous solution prepared by dissolving 10 g of the above Intermediate Compound (C), 2.8 g of phenylboronic acid (available from Aldrich Corporation), 0.5 g of tetrakis triphenylphosphine palladium (O) (available from N.E.CHEMCAT Co., Ltd.), 130 milliliter of dimethoxyethane (available from Wako Pure Chemical Industries, Ltd.) and 6.5 g of sodium carbonate (available from Wako Pure Chemical Industries, Ltd.) into 30 milliliter of water was placed into a flask with a capacity of 500 milliliter, and the solution was stirred at the temperature of 78 °C for 26 hours. After the reaction, the solution was naturally cooled down to room temperature, and precipitated crystals were taken by filtration. The crystals were heated and dissolved in toluene, and the resultant solution was filtered under heating. Then, the mother liquor was condensed and the precipitated crystals were taken by filtration. The crystals were crystallized again with the use of toluene, and 4.7 g of white powders were obtained (yield: 47 %).

As a result of the measurement in accordance with FD-MS, a central peak of m/z= 484 was found for C₃₆H₂₄N₂= 484 and the white powders were identified as the aimed compound (37).

### Synthesis Example 6 (Synthesis of Compound (38))

Under the atmosphere of argon gas ventilation, an aqueous solution prepared by dissolving 8.4 g of the above Intermediate Compound (C) in the above Synthesis Example 4 (1), 3.9 g of 4-biphenylboronic acid (available from Aldrich Corporation), 0.4 g of tetrakis triphenylphosphine palladium (O) (available from N.E.CHEMCAT Co., Ltd.), 110 milliliter of dimethoxyethane (available from Wako Pure Chemical Industries, Ltd.) and 5.7 g of sodium carbonate (available from Wako Pure Chemical Industries, Ltd.) into 27 milliliter of water was placed into a flask with a capacity of 500 milliliter, and the solution was stirred at the temperature of 78 °C for 16 hours.

After the reaction, the solution was naturally cooled down to room temperature, and precipitated crystals were taken by filtration. The crystals were heated and dissolved in toluene, and the resultant solution was filtered under heating. Then, the mother liquor was condensed and the precipitated crystals were taken by filtration. The crystals were crystallized again with the use of toluene, and 6.3 g of white powders were obtained (yield: 63 %).

As a result of the measurement in accordance with FD-MS, a central peak of m/z= 560 was found for C₄₂H₂₈N₂= 560 and the white powders were identified as the aimed compound (38).

### Synthesis Example 6 (Synthesis of Compound (39))

Under the atmosphere of argon gas ventilation, an aqueous solution prepared by dissolving 8.7 g of the above Intermediate Compound (C) in the above Synthesis Example 4 (1), 3.9 g of 2-biphenylboronic acid (available from Aldrich Corporation), 0.4 g of tetrakis triphenylphosphine palladium (O) (available from N.E.CHEMCAT Co., Ltd.), 110 milliliter of dimethoxyethane (available from Wako Pure Chemical Industries, Ltd.) and 5.7 g of sodium carbonate (available from Wako Pure Chemical Industries, Ltd.) into 27 milliliter of water was placed into a flask with a capacity of 500 milliliter, and the solution was stirred at the temperature of 78 °C for 14 hours.

After the reaction, the solution was naturally cooled down to room temperature, and precipitated crystals were taken by filtration. The crystals were heated and dissolved in toluene, and the resultant solution was filtered under heating. Then, the mother liquor was condensed and the precipitated crystals were taken by filtration. The crystals were crystallized again with the use of toluene, and 5.6 g of white powders were obtained (yield: 56 %).

As a result of the measurement in accordance with FD-MS, a central peak of m/z= 560 was found for C₄₂H₂₈N₂= 560 and the white powders were identified as the aimed compound (39).

### Synthesis Example 7 (Synthesis of Compound (40))

Under the atmosphere of argon gas ventilation, an aqueous solution prepared by dissolving 9.1 g of the above Intermediate Compound (C) in the above Synthesis Example 4 (1), 3.5 g of 1-naphthaleneboronic acid (available from Aldrich Corporation), 0.4 g of tetrakis triphenylphosphine palladium (O) (available from N.E.CHEMCAT Co., Ltd.), 120 milliliter of dimethoxyethane (available from Wako Pure Chemical Industries, Ltd.) and 6.0 g of sodium carbonate (available from Wako Pure Chemical Industries, Ltd.) into 27 milliliter of water was placed into a flask with a capacity of 500 milliliter, and the solution was stirred at the temperature of 78 °C for 14 hours.

After the reaction, the solution was naturally cooled down to room temperature, and precipitated crystals were taken by filtration. The crystals were heated and dissolved in toluene, and the resultant solution was filtered under heating. Then, the mother liquor was condensed and the precipitated crystals were taken by filtration. The crystals were crystallized again with the use of toluene, and 6.3 g of white powders were obtained (yield: 63 %).

As a result of the measurement in accordance with FD-MS, a central peak of m/z= 534 was found for C₄₀H₂₆N₂= 534 and the white powders were identified as the aimed compound (40).

### Synthesis Example 8 (Synthesis of Compound (41))

Under the atmosphere of argon gas ventilation, an aqueous solution prepared by dissolving 9.1 g of the above Intermediate Compound (C) in the above term (1) in Synthesis Example 4, 3.5 g of 2-naphthaleneboronic acid (available from Aldrich Corporation), 0.4 g of tetrakis triphenylphosphine palladium (O) (available from N.E.CHEMCAT Co., Ltd.), 120 milliliter of dimethoxyethane (available from Wako Pure Chemical Industries, Ltd.) and 6.0 g of sodium carbonate (available from Wako Pure Chemical Industries, Ltd.) into 27 milliliter of water was placed into a flask with a capacity of 500 milliliter, and the solution was stirred at the temperature of 78 °C for 15 hours.

After the reaction, the solution was naturally cooled down to room temperature, and precipitated crystals were taken by filtration. The crystals were heated and dissolved in toluene, and the resultant solution was filtered under heating. Then, the mother liquor was condensed and the precipitated crystals were taken by filtration. The crystals were crystallized again with the use of toluene, and 5.3 g of white powders were obtained (yield: 53 %).

As a result of the measurement in accordance with FD-MS, a central peak of m/z= 534 was found for C₄₀H₂₆N₂= 534 and the white powders were identified as the aimed compound (41).

### Synthesis Example 9 (Synthesis of Compound (42))

Under the atmosphere of argon gas ventilation, an aqueous solution prepared by dissolving 9.1 g of the above Intermediate Compound (C) in the above term (1) in Synthesis Example 4, 4.2 g of 9-phenanthleneboronic acid (available from Aldrich Corporation), 0.4 g of tetrakis triphenylphosphine palladium (O) (available from N.E.CHEMCAT Co., Ltd.), 110 milliliter of dimethoxyethane (available from Wako Pure Chemical Industries, Ltd.) and 5.5 g of sodium carbonate (available from Wako Pure Chemical Industries, Ltd.) into 26 milliliter of water was placed into a flask with a capacity of 500 milliliter, and the solution was stirred at the temperature of 78 °C for 14 hours.

After the reaction, the solution was naturally cooled down to room temperature, and precipitated crystals were taken by filtration. The crystals were heated and dissolved in toluene, and the resultant solution was filtered under heating. Then, the mother liquor was condensed and the precipitated crystals were taken by filtration. The crystals were crystallized again with the use of toluene, and 6.8 g of white powders were obtained (yield: 68 %).

As a result of the measurement in accordance with FD-MS, a central peak of m/z= 584 was found for C₄₄H₂₈N₂= 584 and the white powders were identified as the aimed compound (42).

### Synthesis Example 10 (Synthesis of Compound (43))

### (1) Synthesis of intermediate compound (F)

Under the atmosphere of argon gas ventilation, 9.0 g of the above Intermediate Compound (C) in the above term (1) in Synthesis Example 4, 100 milliliter of dehydrated toluene (available from Wako Pure Chemical Industries, Ltd.) and 100 milliliter of dehydrated ether (available from Wako Pure Chemical Industries, Ltd.) were placed into a flask with a capacity of 300 milliliter, and the solution was cooled by ice down to the temperature of -10 °C, followed by adding 14.8 of 1.6M-butyllithium (available from Kanto Chemical company) dropwise and the resultant solution was further stirred for 2 hours.

Further, adding 10.4 g of boronic acid triisopropyl ester (available from TOKYO KASEI CO., Ltd.), the resultant solution was set back to room temperature and stirred for 12 hours.

Afterwards, the solution was further cooled by ice, and further, at the temperature of 10 °C or lower, adding dilute hydrochloric acid made by adding 14 milliliter of concentrated hydrochloric acid into 100 milliliter of water, followed by separating an organic layer, and after drying with the use of anhydride magnesium sulfide, it was vacuum concentrated. Dissolving the resultant viscous liquid into 30 milliliter of tetrahydrofuran (THF), and adding hexane, crystals were precipitated.

Separating the precipitated crystals by filtration, 5.9 g of 3,5-bis(carbazolyl-9-yl) benzene boronic acid (Intermediate Compound (F)) was obtained.

### (2) Synthesis of aimed compound (43)

Under the atmosphere of argon gas ventilation, an aqueous solution prepared by dissolving 5.6 g of the above Intermediate Compound (C) obtained in the above term (1) of Synthesis Example 4, 5.6 g of Intermediate Compound (F) obtained in the above term (1), 0.3 g of tetrakis triphenylphosphine palladium (O) (available from N.E.CHEMCAT Co., Ltd.), 110 milliliter of dimethoxyethane (available from Wako Pure Chemical Industries, Ltd.) and 3.6 g of sodium carbonate (available from Wako Pure Chemical Industries, Ltd.) into 17 milliliter of water was placed into a flask with a capacity of 500 milliliter, and the solution was stirred at the temperature of 78 °C for 15 hours.

After the reaction, the solution was naturally cooled down to room temperature, and precipitated crystals were taken by filtration. The crystals were heated and dissolved in toluene, and the resultant solution was filtered under heating. Then, the mother liquor was condensed and the precipitated crystals were taken by filtration. The crystals were crystallized again with the use of toluene, and 4.5g g of white powders was obtained (yield: 48 %).

As a result of the measurement in accordance with FD-MS, a central peak of m/z= 815 was found for C₆₀H₃₈N₄= 815 and the white powders were identified as the aimed compound (43).

### Example 1 (Preparation of an organic EL device)

A glass substrate (manufactured by GEOMATEC Company) with a dimension of 25 mm×75 mm and 0.7 mm in thickness having an ITO transparent electrode was cleaned by application of ultrasonic wave in isopropyl alcohol for 5 minutes and then by exposure to ozone generated by ultraviolet light for 30 minutes. The glass substrate having the transparent electrode which had been cleaned was attached to a substrate holder of a vacuum vapor deposition apparatus. On the surface of the cleaned substrate at the side having the transparent electrode, a film of copper phthalocyanine (referred to as "CuPc film", hereinafter) having a thickness of 10 nm was formed in a manner such that the formed film covered the transparent electrode. The formed CuPc film worked as the hole injecting layer. On the formed CuPc film, a film of 4,4'-bis [N-(4-biphenyl)-N-(4-biphenyl) amino] biphenyl (referred to as "TBAB film", hereinafter) having a thickness of 30 nm was formed. The formed TBAB film worked as the hole transporting layer. On the formed TBAB film, a film of Compound (1) prepared above having a thickness of 40 nm was formed using Compound (1) as the host material, and the light emitting layer was formed. At the same time, tris(2-phenylpyridine)Ir (referred to as "(I-1)", hereinafter) was added as the Ir metal complex dopant emitting phosphorescent light. This film worked as the light emitting layer. The content of (I-1) in the light emitting layer was 5% by weight. On the film formed above, a film of (1,1'-bisphenyl)-4-olato)bis(2-methyl-8-quinolinolato)almninum shown below (referred to as "BAlq film", hereinafter) having a thickness of 10 nm was formed. BAlq film worked as the hole barrier layer. On this film, a film of an aluminum complex of 8-hydroxyquinoline shown below (referred to as "Alq film", hereinafter) having a thickness of 20 nm was formed. Alq film worked as the electron injecting layer. Then, LiF which is an alkali metal halide was vapor deposited to form a film having a thickness of 0.2 nm. On the formed film, aluminum was vapor deposited to form a film having a thickness of 150 nm. The Al/LiF film worked as the cathode. An organic EL device was prepared in the manner described above.

The triplet energy gap and the singlet energy gap of the host material used in the light emitting layer and its glass transition temperature were measured respectively. The results are shown in Table 1.

The device prepared above was examined by passing electric current. Green light was emitted at a luminance of 104 cd/m² under a voltage of 5.2 V and a current density of 0.24 mA/cm². The chromaticity coordinates were (0.32, 0.61), and the current efficiency was 42.6 cd/A. Further, current efficiency after storage at the temperature of 105 °C for 500 hours was 41.6 cd/A, and light emitting surface was uniform without appearing any defect, revealing rectification ratio (forward electric current / reverse electric current) was 1 × 10⁵ or greater. These results are shown in Table 2.

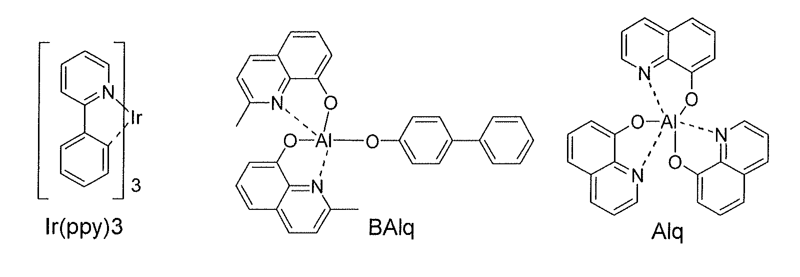

### Examples 2 to 5

Organic EL devices were prepared in accordance with the same procedures as those conducted in Example 1 except that compounds shown in Table 1 were used in place of Compound (1), and the triplet energy, the singlet energy, the voltage, the current density, the luminance, the current efficiency and the chromaticity were measured in accordance with the same methods as those conducted in Example 1. The results are shown in Tables 1 and 2. Further, all the light emitting surfaces of the organic EL devices in Examples 2 to 5 after storage at the temperature of 105 °C for 500 hours was uniform without appearing any defect, and revealed rectification ratio (forward electric current / reverse electric current) of 1 × 10⁵ or greater.

### Comparative Example 1

An organic EL device was prepared in the same manner as Example 1 except that CBP (4,4-N,N-dicarbazolyl biphenyl) was employed as the host material in the light emitting layer instead of Compound (1). The triplet energy gap, the singlet energy gap, the glass transition temperature, voltage, current density, luminance, current efficiency, and chromaticity were similarly measured also about the devices obtained in Comparative Example 1. The results are shown in Tables 1 and 2. Although 10 devices were prepared, all the resultant devices exhibited generation of defects over the light emitting surfaces easily from the start. Further, leak currents showing symptom of short circuit greatly appeared, and rectification ratio (forward electric current / reverse electric current) was 1 × 10⁴ or smaller. Furthermore, after storage at the temperature of 105 °C for 500 hours, defects appeared over the light emitting surface, and the rectification ratio was 1 × 10³ or smaller. Moreover, the luminance was only several cd/m² which means remarkable degradation.

**Table 1**

| | Host material in the light emitting layer | Triplet energy gap | Singlet energy gap | Glass transition temperature |
|---|---|---|---|---|
| | | (eV) | (eV) | (°C) |
| Ex. 1 | (1) | 2.9 | 3.7 | 128 |
| Ex. 2 | (4) | 2.9 | 3.7 | 125 |
| Ex. 3 | (38) | 2.7 | 3.57 | 123.4 |
| Ex. 4 | (42) | 2.64 | 3.57 | 130.5 |
| Ex. 5 | (43) | 2.88 | 3.57 | 181.9 |
| Co. Ex. 1 | CBP | 2.81 | 3.6 | 105 |

**Table 2-1**

| | Host material in the light emitting layer | Voltage | Current density | Luminance | Current efficiency |
|---|---|---|---|---|---|
| | | (V) | (mA/cm²) | (cd/m²) | (cd/A) |
| Ex. 1 | (1) | 5.2 | 0.24 | 104 | 42.6 |
| Ex.2 | (4) | 5.8 | 0.27 | 99 | 36.1 |
| Ex.3 | (38) | 5.5 | 0.3 | 99.1 | 39.7 |
| Ex. 4 | (42) | 6.1 | 0.3 | 102.5 | 32.4 |
| Ex.5 | (43) | 5.9 | 0.3 | 105.8 | 38.5 |
| Co. Ex. 1 | CBP | 6 | 0.28 | 103 | 32.1 |

**Table 2-2**

| | Current efficiency after storage at the temperature of 105 °C for 500 hours | Chromaticity | Color of light emission |
|---|---|---|---|
| | (cd/A) | (x,y) | |
| Ex. 1 | 41.6 | (0.32,0.61) | Green |
| Ex. 2 | 35.4 | (0.32,0.61) | Green |
| Ex. 3 | 39.6 | (0.32,0.61) | Green |
| Ex. 4 | 32.4 | (0.32,0.61) | Green |
| Ex. 5 | 38.5 | (0.32,0.61) | Green |
| Co. Ex. 1 | 15.7 | (0.32,0.61) | Green |

As shown in Table 2, it was verified that the organic EL device with the use of the material for organic EL device of the present invention emits green light with an enhanced current efficiency even after storage under an elevated temperature. It was also verified that because the material for the organic EL device of the present invention has high glass transition-temperature and because it has a symmetry of low order, the current efficiency exhibited almost no decrease and the rectification ratio was extremely as high as 1 × 10⁵ or greater even after storage under an elevated temperature. Still further, as the Comparative Example 1 verified, the compound such as CBP or so in which tough carbazolyl groups are disposed in good symmetry caused defects over the light emitting surface easily, and exhibited decrease of the current efficiency after storage under an elevated temperature. Accordingly, it became apparent that a compound with poor symmetry having m-terphenyl structure in the organic EL device of the present invention is effective in a viewpoint of suppressing defects over the light emitting surface.

### INDUSTRIAL APPLICABILITY

As the above explanation in detail, employing the compound represented by general formula (1) of the present invention as the material for an organic electroluminescence device provides the organic electroluminescence device with an enhanced current efficiency, without any pixel defects and is superior in heat resistance. Therefore, the organic EL device of the present invention is very useful for applications such as light sources of various electronic instruments.

## Claims

1. A material for an organic electroluminescence device which comprises a compound represented by general formula (1): 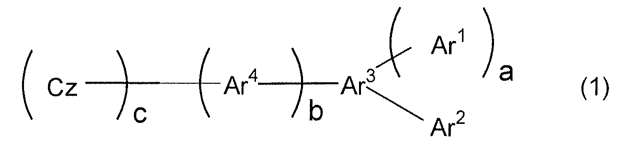 wherein Cz represents wherein Cz represents a carbazolyl group, an arylcarbazoleyl group having 18 to 60 carbon atoms, an azacarbazolyl group, an arylazacarbazoleyl group having 18 to 60 carbon atoms, an acridinyl group, a phenoxazinyl group or dibenzoazevinyl group each may have a substituent;
Ar¹ and Ar² each independently represents a substituted or unsubstituted aryl group having 6 to 60 carbon atoms or a substituted or unsubstituted heterocyclic group having 3 to 60 carbon atoms;
Ar³ represents an aromatic hydrocarbon group having 6 to 60 carbon atoms or a substituted or unsubstituted heterocyclic group having 3 to 60 carbon atoms;
Ar⁴ represents a substituted or unsubstituted benzene residue, a substituted or unsubstituted thiophene residue, a substituted or unsubstituted triazole residue, a substituted or unsubstituted fluorene residue or a substituted or unsubstituted spirobifluorene residue;
a represents an integer of 0 or 1, b represents an integer of 0 to 4, and c represents an integer of 1 to 3; and when there are plural of Cz and when there are plural of Ar⁴, they may be the same with or different from each other;
with a proviso that when a= 0 and c=1, a case where both Ar³ and Ar⁴ represent benzene residues and Ar² represents a phenyl carbazolyl group or a carbazolyl group is omitted;
further, when a= 1, b= 0 and c= 1, a case where Ar³ represents a benzene residue and both Ar¹ and Ar² represent phenyl carbazolyl groups is omitted; and
furthermore, when b= 0 and c= 1, a case where Ar³ represents a benzene residue and all of Ar¹, Ar² and Cz represent a carbazolyl group or a phenyl carbazolyl group is omitted.

2. The material for an organic electroluminescence device according to Claim 1, wherein said Ar⁴ is represented by the following formulae: 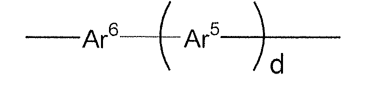 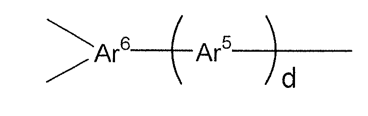 or 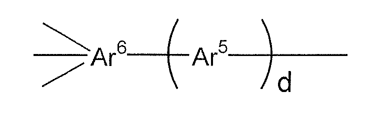 wherein Ar⁵ and Ar⁶ each independently is defined as the same with Ar⁴, d represents an integer of 0 to 3, and
when there are plural of Ar⁵, they may be the same with or different from each other.

3. The material for an organic electroluminescence device according to Claim 1, wherein a= 0.

4. The material for an organic electroluminescence device according to Claim 1, wherein a= 0 and b= 0.

5. The material for an organic electroluminescence device according to Claim 1, wherein a= 0, b= 0 and c represents an integer of 2 or 3.

6. The material for an organic electroluminescence device according to Claim 1, wherein said compound represented by general formula (1) works as a host material in the organic electroluminescence device.

7. An organic electroluminescence device comprising an anode, a cathode and at least one organic thin film layer including a light emitting layer sandwiched between the anode and the cathode, wherein at least one of the organic thin film layer comprises the material for an organic electroluminescence device according to Claim 1.

8. The organic electroluminescence device according to Claim 7, wherein a= 0.

9. The organic electroluminescence device according to Claim 7, wherein a= 0 and b= 0.

10. The organic electroluminescence device according to Claim 7, wherein a= 0, b= 0 and c represents an integer of 2 or 3.

11. The organic electroluminescence device according to Claim 7, wherein said light emitting layer consists of a host material and a phosphorescent material and wherein the host material comprises the material for an organic electroluminescence device according to Claim 1.

12. The organic electroluminescence device according to Claim 7, wherein a reductive dopant is added in an interfacial zone between said cathode and said organic thin film layer.

13. The organic electroluminescence device according to Claim 7, which further comprises an electron injecting layer between said light emitting layer and said cathode and wherein the electron injecting layer comprises a derivative of cyclic compound having nitrogen atom.
